# FASCICULE DE BREVET EUROPEEN

(11) **EP 3 764 409 B1**
(45) Date de publication et mention de la délivrance du brevet: **06.04.2022**
(21) Numéro de dépôt: 20184589.8
(22) Date de dépôt: 07.07.2020
(51) Int. Cl.: H01L 33/06, B82Y 20/00, H01L 33/20, G02B 6/122, H01L 31/0352, H01S 5/34

(54) **SOURCE DE PHOTONS UNIQUES A FACTEUR D'INDISCERNABILITE ELEVE**
QUELLE EINZELNER PHOTONEN MIT EINEM HOHEN UNUNTERSCHEIDBARKEITSFAKTOR
SINGLE PHOTON EMISSION SOURCE WITH HIGH INDISCERNIBILITY FACTOR

(30) Priorité: 10.07.2019 FR 1907759
(43) Date de publication de la demande: 13.01.2021
(73) Titulaire: Commissariat à l'Energie Atomique et aux Energies Alternatives, 75015 Paris (FR)
(72) Inventeur: GERARD, Jean-Michel, 38054 GRENOBLE (FR); CLAUDON, Julien, 38054 GRENOBLE (FR)
(74) Mandataire: INNOV-GROUP

(56) Documents cités:
- US-A1- 2006 280 414
- GERARD JEAN-MICHEL ET AL: "Very Efficient Single-Photon Sources Based on Quantum Dots in Photonic Wires", 2014 INTERNATIONAL SEMICONDUCTOR LASER CONFERENCE, IEEE, 7 septembre 2014 (2014-09-07), pages 1-2, XP032710103, DOI: 10.1109/ISLC.2014.133
- CHRIS L DREE{\SS}EN ET AL: "Suppressing phonon decoherence of high performance single-photon sources in nanophotonic waveguides", ARXIV.ORG, CORNELL UNIVERSITY LIBRARY, 201 OLIN LIBRARY CORNELL UNIVERSITY ITHACA, NY 14853, 15 juin 2018 (2018-06-15), XP081140347, DOI: 10.1088/2058-9565/AADBB8
- MERMILLOD Q ET AL: "Harvesting, coupling and control of single exciton coherences in photonic waveguide antennas", ARXIV.ORG, CORNELL UNIVERSITY LIBRARY, 201 OLIN LIBRARY CORNELL UNIVERSITY ITHACA, NY 14853, 8 avril 2016 (2016-04-08), XP080964155, DOI: 10.1103/PHYSREVLETT.116.163903

## Description

### DOMAINE TECHNIQUE

Le domaine de l'invention est celui des sources de photons uniques comportant un fil photonique contenant un émetteur de photons uniques, dont on cherche à améliorer le facteur d'indiscernabilité. L'invention présente une application notamment dans les domaines de la cryptographie, des communications quantiques, du calcul quantique photonique et de la métrologie.

### ÉTAT DE LA TECHNIQUE ANTÉRIEURE

Il existe des sources de photons uniques, dont les domaines d'application se trouvent par exemple dans la cryptographie, les communications quantiques, le calcul quantique photonique, la métrologie. D'une manière générale, une source de photons uniques est une source lumineuse capable d'émettre à la demande des impulsions lumineuses contenant chacune un seul photon. On cherche à ce que les photons émis présentent le même état, en termes de fréquence, de polarisation et de forme de paquet d'onde.

Les sources de photons uniques sont caractérisées par plusieurs facteurs de mérite, dont le facteur de pureté P qui caractérise l'absence d'impulsion émise contenant plus de 1 photon, le facteur d'efficacité E qui exprime la probabilité que l'impulsion émise contienne effectivement un seul photon, et le facteur d'indiscernabilité I qui rend compte de la 'ressemblance' de deux photons émis dans des impulsions distinctes.

Une source de photons uniques comporte un émetteur de photons uniques, lequel forme alors un atome artificiel, c'est-à-dire un système à deux niveaux d'énergie distincts, à savoir un état fondamental |g〉 et un état excité |e〉. Il peut s'agir, entre autres, d'une boîte quantique semiconductrice ou encore d'un centre coloré d'un cristal de diamant. Lorsqu'on excite l'atome artificiel optiquement ou électriquement, celui-ci repasse du premier état excité |e〉 à l'état fondamental |g〉 en émettant un unique photon dont la longueur d'onde correspond à la différence d'énergie entre ces deux états. C'est le phénomène d'émission spontanée. La source de photons uniques peut présenter notamment deux configurations différentes, selon que l'émetteur de photons uniques est disposé dans une microcavité optique résonante ou dans un nanofil photonique formant un guide d'onde monomode.

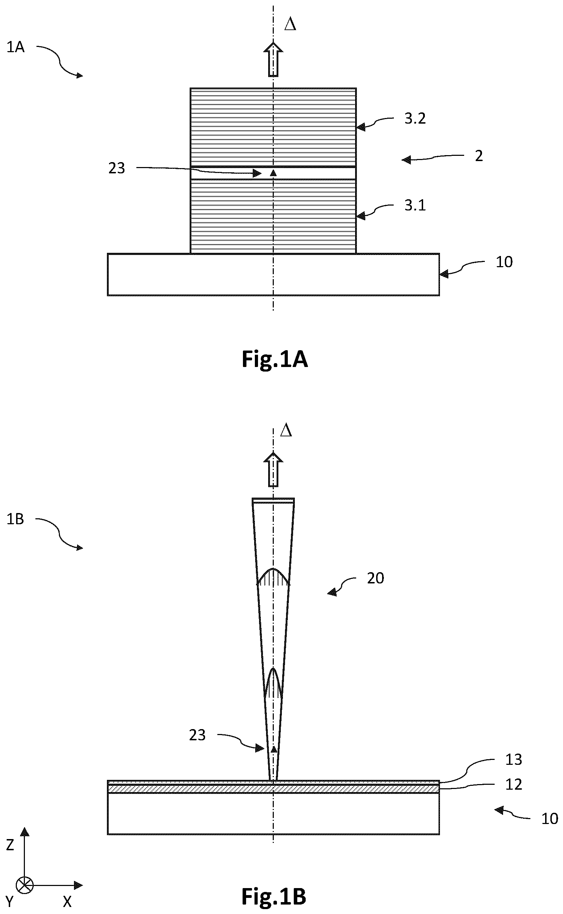

La figure 1A illustre un exemple d'une source de photons uniques 1A selon une première configuration, dans laquelle une boîte quantique semiconductrice 23 est située dans un pilier 2 formant une microcavité optique résonante. Le pilier 2 repose sur un substrat support 10 et est orienté suivant un axe longitudinal Δ orthogonal au plan XY du substrat support 10. Le pilier 2 comporte une boîte quantique semiconductrice 23 réalisée en InAs placée dans une couche en GaAs, celle-ci étant située entre deux miroirs de Bragg 3.1, 3.2 réalisés en GaAs/AlAs. Le diamètre local du pilier 2 reste sensiblement constant le long de l'axe longitudinal Δ, et est de l'ordre du micron, par exemple égal à 1µm environ. Cette microcavité résonante 2 comporte des modes résonants discrets, et la boîte quantique semiconductrice 23 présente une énergie de bande interdite qui correspond de préférence au mode fondamental de la microcavité résonante 2, de sorte que l'émission de la boîte quantique semiconductrice 23 est fortement accélérée par effet Purcell. Aussi, la probabilité d'injecter un photon dans le mode fondamental de la microcavité résonante 2 est proche de 1. Cependant, de telles sources de photons uniques 1A ne permettent actuellement pas d'obtenir à la fois un facteur d'efficacité E élevé et un facteur d'indiscernabilité I élevé.

La figure 1B illustre un exemple d'une source de photons uniques 1B selon une deuxième configuration, dans laquelle une boîte quantique semiconductrice 23 est située dans un fil photonique 20 formant un guide d'onde monomode. Le fil photonique 20 repose sur un substrat support 10 qui contient une couche réflectrice 12 revêtue d'une couche diélectrique 13. Le fil photonique 20 ne supporte qu'un seul mode optique dans sa section droite la plus étroite, et présente une variation longitudinale de son diamètre local de manière à former un adaptateur de mode permettant d'optimiser l'extraction lumineuse hors du fil photonique 20 avec un diagramme d'émission de forme gaussienne à faible ouverture numérique. Dans cet exemple, le fil photonique 20 présente une forme générale évasée, mais une forme effilée est également possible. Un tel fil photonique 20 est notamment décrit dans l'article de Munsch et al. intitulé Dielectric GaAs antenna ensuring an efficient broadband coupling an InAs quantum-dot light emitter and a gaussian optical beam, Phys. Rev. Lett. 110, 177402 (2013). Dans cet exemple, le fil photonique 20 est réalisé en un matériau cristallin de haut indice et comporte une boîte quantique semiconductrice 23 en InAs. Une telle source de photons uniques 1B permet d'obtenir un facteur d'efficacité E particulièrement élevé, supérieur à 0.75, et pouvant avoisiner 0.92 (Munsch 2013). La publication "Very Efficient Single-Photon Sources Based on Quantum Dots in Photonic Wires", GERARD ET AL, INTERNATIONAL SEMICONDUCTOR LASER CONFERENCE, IEEE, 7 septembre 2014, divulgue une source de photons uniques similaire de l'art antérieur.

Cependant, il existe un besoin de disposer d'une source de photons uniques présentant un facteur d'indiscernabilité I élevé tout en conservant un facteur d'efficacité E également élevé. Or, il apparaît que les propriétés de l'émetteur peuvent être impactées par les vibrations mécaniques du fil photonique, ce qui peut conduire à une dégradation du facteur d'indiscernabilité I de la source de photons uniques (cf. notamment l'article de Yeo et al. intitulé Strain-mediated coupling in a quantum dot-mechanical oscillator hybrid system, Nat. Nanotechnol. 9, 106-110, 2014).

### EXPOSÉ DE L'INVENTION

L'invention a pour objectif de remédier au moins en partie aux inconvénients de l'art antérieur, et plus particulièrement de proposer une source de photons uniques à fil photonique formant un guide d'onde monomode, dont le facteur d'indiscernabilité I est amélioré.

Pour cela, l'objet de l'invention est une source de photons uniques comportant :
- un substrat support comportant une couche réflectrice ; et
- un fil photonique :
   o reposant sur le substrat support et disposé en regard de la couche réflectrice, et s'étendant suivant un axe longitudinal Δ sensiblement orthogonal au plan du substrat support,
   o comportant un émetteur de photons uniques,
   o formant un guide d'onde monomode pour les photons uniques, et
   o présentant des dimensions transversales variant longitudinalement en direction d'une extrémité supérieure du fil photonique, de manière à former un adaptateur de mode pour un mode optique guidé.

Selon l'invention, le fil photonique est formé de deux parties coaxiales, distinctes et distantes l'une de l'autre suivant l'axe longitudinal Δ, à savoir : une partie inférieure, reposant au contact du substrat support, dans laquelle est disposé l'émetteur; et une partie supérieure, suspendue au-dessus de la partie inférieure et couplée optiquement à celle-ci.

De plus, la source de photons uniques comporte une structure de maintien comportant : au moins un pilier reposant au contact du substrat support et disposé de manière adjacente au fil photonique ; et au moins un bras de maintien reliant mécaniquement la partie supérieure au pilier et maintenant la partie supérieure suspendue au-dessus de la partie inférieure.

Certains aspects préférés mais non limitatifs de cette source de photons uniques sont les suivants.

De préférence, la partie inférieure présente un volume inférieur à celui de la partie supérieure.

De préférence, la partie supérieure comporte l'adaptateur de mode.

De préférence, la partie supérieure est espacée de la partie inférieure d'une distance dₛₚ comprise entre 5nm et λₑ/n, où λₑ est la longueur d'onde des photons émis par l'émetteur et où n est l'indice de réfraction du matériau cristallin du fil photonique.

Le fil photonique et le pilier peuvent être réalisés à base d'un même matériau cristallin.

Le pilier peut comporter une portion intercalaire en un matériau sacrificiel, disposée entre deux parties du pilier réalisées en le matériau cristallin, cette portion intercalaire étant coplanaire avec l'espacement entre les parties inférieure et supérieure du fil photonique.

Le bras de maintien peut être réalisé en ledit même matériau cristallin, et peut s'étendre dans un plan parallèle au plan du substrat support à partir d'une bordure latérale de la partie supérieure.

Le bras de maintien peut être réalisé en un matériau différent dudit matériau cristallin, et peut s'étendre sur et au contact d'une extrémité supérieure du fil photonique opposée au substrat support.

Le fil photonique peut présenter une forme évasée ou une forme effilée suivant une direction opposée au substrat support.

Le fil photonique peut présenter une forme effilée, et le bras de maintien peut comporter une portion de maintien partiellement au contact de la partie supérieure, la portion de maintien présentant une symétrie de rotation autour de l'axe longitudinal Δ ainsi qu'une dimension moyenne dans un plan parallèle au substrat support supérieure à une valeur maximale des dimensions transversales du fil photonique.

Le fil photonique peut être réalisé à base d'un matériau cristallin choisi parmi les composés III-V ou les composés II-VI, et l'émetteur peut être formé d'au moins une boîte quantique semiconductrice.

L'invention porte également sur un procédé de fabrication d'une source de photons uniques selon l'une quelconque des caractéristiques précédentes, comportant les étapes suivantes :
- réalisation d'un empilement comportant : un substrat support comportant une couche réflectrice revêtue d'une couche diélectrique d'arrêt de gravure ; une première et une deuxième sous-couches destinées à former la partie inférieure, reposant au contact de la couche diélectrique, réalisées en un matériau cristallin dit de haut indice, et entre lesquelles est située un émetteur ; une couche sacrificielle reposant au contact de la deuxième sous-couche ; une deuxième couche destinée à former la partie supérieure, reposant au contact de la couche sacrificielle ;
- gravure partielle de l'empilement de manière à former le pilier et le fil photonique, une portion de la couche sacrificielle participant alors à définir une bordure latérale du pilier, et une portion de la couche sacrificielle participant alors à définir une bordure latérale du fil photonique ;
- gravure sélective de la couche sacrificielle de manière à supprimer la portion de la couche sacrificielle du fil photonique, et assurant ainsi la suspension de la partie supérieure au-dessus de la partie inférieure, tout en préservant au moins une partie de la portion de la couche sacrificielle du pilier.

Le bras de maintien peut être réalisé lors de l'étape de formation du pilier et du fil photonique, de sorte qu'il assure la liaison mécanique entre le pilier et la partie supérieure du fil photonique.

A la suite de l'étape de formation du pilier et du fil photonique, la partie supérieure peut ne pas être liée mécaniquement au pilier. Le procédé peut alors comporter les étapes suivantes :
- dépôt d'une couche d'encapsulation recouvrant le pilier et le fil photonique, et planarisation de la couche d'encapsulation de manière à rendre libre une extrémité supérieure du pilier et une extrémité supérieure du fil photonique ;
- réalisation d'un bras de maintien s'étendant sur la couche d'encapsulation et au contact de l'extrémité supérieure du pilier et de l'extrémité supérieure du fil photonique ;
- suppression de la couche d'encapsulation ;
- gravure sélective de la couche sacrificielle, assurant ainsi la suspension de la partie supérieure au-dessus de la partie inférieure.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1A et 1B, déjà décrites, sont des vues schématiques et partielle en coupe longitudinale de deux sources de photons uniques selon des exemples de l'art antérieur, comportant une microcavité résonante (fig.1A) ou un fil photonique monomode (fig.1B) ;
les figures 2A et 2B sont des vues schématiques et partielles, en perspective (fig.2A) et en coupe longitudinale (fig.2B) d'une source de photons uniques selon un premier mode de réalisation dans lequel le fil photonique présente une forme générale évasée ;
la figure 3A est une vue schématique d'une source de photons uniques comportant un dispositif d'excitation optique et un dispositif de collection selon une première variante ; et
la figure 3B est une vue schématique et partielle d'une source de photons uniques comportant un dispositif d'excitation optique selon une deuxième variante ;
les figures 4A et 4B sont des exemples d'évolution du facteur d'indiscernabilité I en fonction de la température T du fil photonique de la source de photons uniques, pour un fil photonique selon un exemple de l'art antérieur (fig.4A) et pour un fil photonique similaire à celui du premier mode de réalisation (fig.4B) ;
les figures 5A à 5H illustrent différentes étapes d'un procédé de fabrication d'une source de photons uniques similaire à celle du premier mode de réalisation ;
les figures 6A et 6B sont des vues schématiques et partielles, en coupe longitudinale (fig.6A) et en vue de dessus (fig.6B), d'une source de photons uniques selon un deuxième mode de réalisation dans lequel le fil photonique présente une forme effilée ;
les figures 7A à 7F illustrent différentes étapes d'un procédé de fabrication d'une source de photons uniques selon le deuxième mode de réalisation.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire. L'usage de l'article indéfini « un » ou « une » pour un élément ou une étape n'exclut pas la présence d'une pluralité de tels éléments ou étapes, sauf mention contraire.

L'invention porte sur une source de photons uniques permettant d'émettre des photons avec un facteur d'indiscernabilité I élevé. La source de photons comporte un fil photonique formant un guide d'onde monomode du type de celui décrit précédemment en référence à la fig.iB au sein duquel se situe un émetteur de photons uniques formant un atome artificiel.

Une source de photons uniques est une source produisant à la demande, par émission spontanée, des impulsions lumineuses ne contenant qu'un seul photon. Deux photons sont dits indiscernables lorsqu'ils sont identiques en termes d'état quantique, c'est-à-dire en termes de polarisation, de fréquence, et de distributions spatiale et temporelle de l'impulsion lumineuse contenant le photon unique.

L'émetteur de photons uniques est assimilable en première approximation à un système à deux niveaux. Comme mentionné précédemment, un tel émetteur présente ainsi un état fondamental |g〉 et un état excité |e〉. Lorsqu'il est porté dans son état excité par une impulsion optique ou électrique, il relaxe spontanément vers son état fondamental |g〉 en émettant, par émission spontanée, un et un seul photon dont la longueur d'onde correspond à la différence d'énergie entre les états excité |e〉 et fondamental |g〉. Un tel émetteur de photons uniques présente ainsi des niveaux d'énergie discrets, et l'on parle alors d'un atome artificiel, par analogie avec les états électroniques discrets d'un atome. Un tel émetteur peut être une boîte quantique semiconductrice, dont le confinement des charges suivant les trois directions de l'espace à une échelle nanométrique rend les niveaux d'énergie discrets. De manière connue, un tel émetteur peut également être choisi parmi des nanocristaux, des molécules, voire des centres colorés d'un solide cristallin isolant (par ex. diamant) ou semiconducteur.

Dans la suite de la description, l'émetteur de photons uniques est une boîte quantique semiconductrice, formée d'un îlot nanométrique d'un composé semiconducteur, par exemple de l'InAs, isolé dans un matériau cristallin de haut indice, par exemple du GaAs, qui forme le fil photonique. Aussi, à basse température (quelques kelvins par exemple), une impulsion laser courte devant la durée de vie radiative de la boîte quantique permet de faire passer celle-ci de son état fondamental |g〉 à son état excité |e〉. La boîte quantique se désexcite en émettant un unique photon par émission spontanée. La source de photons uniques, par excitation successive de la boîte quantique, émet ainsi par émission spontanée des photons à différents instants distants dans le temps.

Cependant, Yeo et al. 2014 ainsi que l'article de Munsch et al. intitulé Resonant driving of a single photon emitter embedded in a mechanical oscillator, Nat. Commun. 8, 76 (2017) ont montré que les propriétés d'une telle boîte quantique peuvent être modifiées par son environnement, et en particulier par les vibrations mécaniques du fil photonique. Plus précisément, une déformation mécanique du fil photonique génère des contraintes mécaniques au sein de la boîte quantique qui fluctuent dans le temps, et entraînent alors une modification dans le temps des propriétés de la boîte quantique, et notamment de la différence d'énergie entre l'état fondamental |g〉 et l'état excité |e〉. En conséquence, au cours de deux émissions successives de photons uniques, la fréquence d'émission fluctue, ce qui donne lieu à des trains d'onde à un seul photon qui sont différents les uns des autres. Cette influence des vibrations mécaniques du fil photonique sur les propriétés de la boîte quantique contribue donc à dégrader le facteur d'indiscernabilité I.

Aussi, la source de photons uniques selon les différents modes de réalisation décrits ci-dessous comporte un fil photonique monomode segmenté en deux parties coaxiales, distinctes et distantes l'une de l'autre suivant l'axe longitudinal Δ, de manière à diminuer l'influence des vibrations mécaniques du fil photonique sur les propriétés de l'émetteur, améliorant ainsi le facteur d'indiscernabilité I de la source de photons uniques.

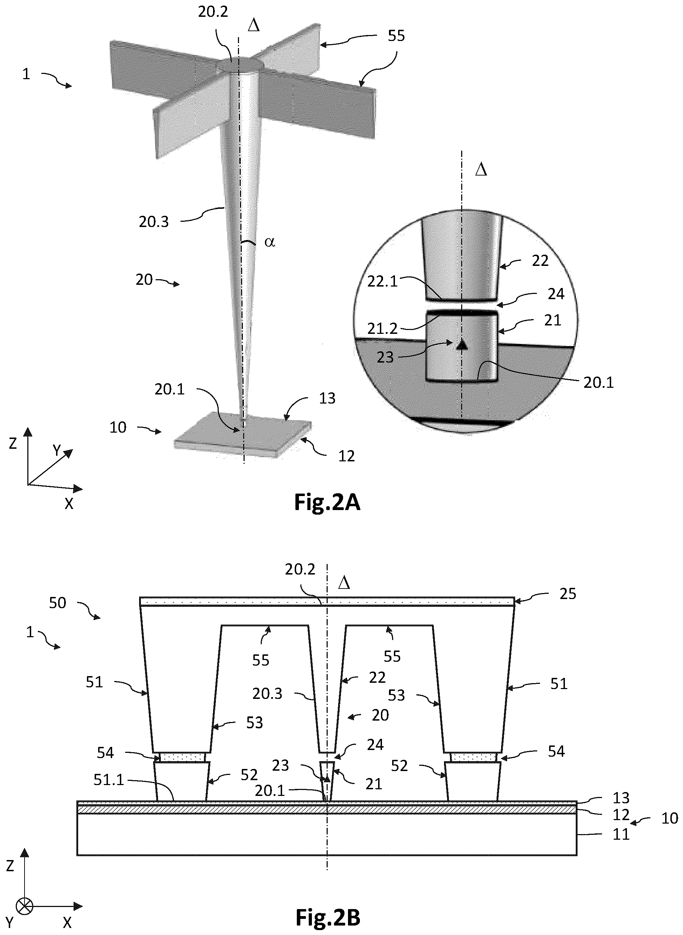

Les figures 2A et 2B sont des vues schématiques et partielles, en perspective (fig.2A) et en coupe longitudinale (fig.2B) d'une source de photons uniques 1 selon un premier mode de réalisation.

D'une manière générale, la source de photons uniques 1 comporte au moins un fil photonique 20 qui repose sur un substrat support 10, une structure de maintien 50 d'une partie du fil photonique 20, un dispositif d'excitation optique 30 adapté à provoquer l'émission spontanée d'un photon unique par l'émetteur 23, et un dispositif de collection 40 adapté à assurer par exemple le couplage optique entre le fil photonique 20 et un guide d'onde externe 43.

Dans ce premier mode de réalisation, le fil photonique 20 présente une forme générale évasée en direction de son extrémité supérieure 20.2, c'est-à-dire qu'il présente un élargissement de son diamètre local à mesure que l'on s'éloigne du substrat support 10. Le fil photonique 20 forme alors une « trompette photonique », selon l'expression donnée notamment dans l'article de Munsch et al. 2013. Par ailleurs, l'émetteur 23 de photons uniques, autrement dit l'atome artificiel, est une boîte quantique réalisée en un matériau semiconducteur et située dans le matériau cristallin de haut indice à base duquel est formé le fil photonique 20.

On définit ici et pour la suite de la description un repère direct tridimensionnel orthogonal XYZ, où les axes X et Y forment un plan parallèle au plan principal du substrat support 10, et où l'axe Z est orienté en direction du fil photonique 20 et est parallèle à l'axe longitudinal de ce dernier. Par ailleurs, les termes « inférieur » et « supérieur » s'entendent comme étant relatifs à un positionnement croissant lorsqu'on s'éloigne du substrat support 10 suivant la direction +Z.

Le substrat support 10 est le substrat sur lequel repose le fil photonique 20. Il est formé d'une couche principale épaisse 11, de préférence rigide, réalisée en un ou plusieurs matériaux. La couche principale 11 peut être une plaque semiconductrice (*wafer,* en anglais) présentant par exemple une épaisseur d'une à plusieurs centaines de microns. Elle peut ici être réalisée en GaAs, dopé ou non.

Une couche réflectrice 12 revêt au moins localement la couche principale 11. Elle est située sous le fil photonique 20 et est adaptée à réfléchir les photons émis par l'émetteur 23 du fil photonique 20. La couche réflectrice 12 peut être réalisée en un matériau métallique, par exemple de l'or d'une épaisseur comprise par exemple entre 100nm et 300nm.

Une couche diélectrique 13 revêt la couche réflectrice 12 et la couche principale 11. Elle est réalisée en un matériau diélectrique et peu absorbant à la longueur d'onde d'émission λₑ, et forme également une couche d'arrêt de gravure vis-à-vis d'agents de gravure utilisés lors de différentes étapes de gravure chimique mises en oeuvre par le procédé de fabrication de la source de photons uniques 1. La couche diélectrique 13 peut être réalisée notamment en un nitrure de silicium, par exemple du Si₃N₄ d'une épaisseur de 9 à 11nm environ.

Le fil photonique 20 repose sur le substrat support 10 et est disposé en regard, c'est-à-dire à la perpendiculaire, de la couche réflectrice 12. D'une manière générale, le fil photonique 20 se présente sous la forme d'un élément tridimensionnel allongé suivant un axe longitudinal Δ sensiblement orthogonal au plan XY du substrat support 10. Autrement dit, il présente une dimension longitudinale (hauteur h) suivant l'axe longitudinal Δ supérieure aux dimensions transversales. Les dimensions transversales du fil photonique 20, c'est-à-dire leurs dimensions dans un plan XY, peuvent être par exemple comprises entre 10nm et 5µm, et de préférence comprises entre 100nm et 2µm. Dans la mesure où les dimensions transversales présentent une variation longitudinale le long de l'axe longitudinal Δ, la hauteur du fil photonique 20 est supérieure aux dimensions transversales maximales, par exemple 2 fois, et de préférence au moins 5 fois supérieure. La hauteur h est définie comme étant la distance, suivant l'axe Z, entre l'extrémité inférieure 20.1 du fil photonique 20 au contact du substrat support 10 et son extrémité supérieure 20.2. L'extrémité inférieure 20.1 et l'extrémité supérieure 20.2 sont reliées entre elles par une bordure latérale 20.3.

La section droite du fil photonique 20, dans un plan XY orthogonal à l'axe longitudinal Δ, peut présenter différentes formes, par exemple une forme circulaire, ovale, polygonale par exemple triangulaire, carrée, rectangulaire, voire hexagonale, selon que l'on souhaite notamment que le mode guidé présente ou non une dégénérescence en polarisation, comme décrit par la suite. On définit ici le diamètre comme étant une grandeur associée au périmètre local du fil photonique 20 pour une section droite. Il peut s'agir du diamètre d'un disque présentant la même surface que la section droite du fil photonique 20. Le diamètre local est le diamètre du fil photonique 20 pour une section droite à une hauteur donnée de celui-ci. Le diamètre moyen est la moyenne, par exemple arithmétique, des diamètres locaux le long du fil photonique 20 ou d'une portion de celui-ci. Dans cet exemple, le fil photonique 20 présente une section droite circulaire le long de l'axe longitudinal Δ.

Le fil photonique 20 est réalisé à base d'au moins un matériau cristallin de haut indice de réfraction. Dans le cas où l'émetteur 23 est une boîte quantique semiconductrice, le matériau cristallin de haut indice est choisi en fonction du composé semiconducteur de la boîte quantique. Ainsi, le matériau cristallin de haut indice peut être un composé III-V, par exemple du GaAs ou de l'InP lorsque la boîte quantique est réalisée en InAs, ou de l'AlN lorsque la boîte quantique est réalisée en GaN. Dans ce premier mode de réalisation, le fil photonique 20 est réalisé en GaAs et comporte au moins une boîte quantique en InAs. D'autres combinaisons de matériaux sont possibles, tant parmi les composés III-V que parmi les composés II-VI, en fonction de la longueur d'onde d'émission λₑ souhaitée. En variante, l'émetteur 23 peut être un centre coloré (défaut unique) d'un cristal de diamant (cf. notamment l'article de Babinec et al. intitulé A diamond nanowire single-photon source, Nat. Nanotechnol., 5,195 (2010)).

L'émetteur 23 est ici au moins une boîte quantique réalisée en un composé semiconducteur dont l'énergie de bande interdite détermine la longueur d'onde λₑ des photons émis. De préférence, le fil photonique 20 ne comporte qu'une seule boîte quantique 23, disposée de préférence sur l'axe longitudinal Δ du fil photonique 20. Il peut ainsi s'agir d'une boîte quantique 23 en InAs disposée dans une couche continue dite de mouillage en InAs qui s'étend dans un plan parallèle au plan XY. En variante, le fil photonique 20 peut comporter plusieurs boîtes quantiques disposées dans une même couche continue de mouillage. La boîte quantique 23 est de préférence disposée à une hauteur de 100nm environ vis-à-vis du substrat support 10, où le diamètre local du fil photonique 20 est de préférence égal à 200nm environ. Dans le cas où l'émetteur 23 est formé de plusieurs boîtes quantiques, celles-ci peuvent ne pas présenter des dimensions rigoureusement identiques, et peuvent alors émettre des photons à des longueurs d'onde légèrement différentes. Dans ce cas, comme décrit plus loin, le dispositif de collection 40 comporte avantageusement un filtre spectral 41 pour ne transmettre que les photons émis par une boîte quantique choisie.

Le fil photonique 20 présente des dimensions transversales (diamètre local) le long de l'axe longitudinal Δ choisies de manière à former un guide d'onde monomode à la longueur d'onde d'émission λₑ, c'est-à-dire un guide d'onde supportant un seul mode optique guidé, par exemple le mode fondamental, en particulier dans la section droite du fil photonique comportant l'émetteur.

Pour cela, le fil photonique 20 est réalisé à base d'un matériau cristallin de haut indice, ici du GaAs d'indice de réfraction n égal à 3.45, qui forme le coeur du guide d'onde. Il est entouré d'un environnement de faible indice de réfraction qui forme la gaine du guide d'onde, par exemple du vide ou un gaz. De plus, pour être monomode, le fil photonique 20 présente un diamètre local, dans la section droite contenant l'émetteur 23, sensiblement égale à λₑ/n. Dans le cas d'une boîte quantique 23 en InAs adaptée à émettre des photons à une longueur d'onde λₑ de 950nm environ, le diamètre local du fil photonique 20 au niveau de la boîte quantique 23 est compris entre 150nm et 300nm environ, de préférence égal à 200nm environ.

La forme de la section droite du fil photonique 20 dans le plan XY peut être choisie de sorte que le fil photonique 20 supporte un mode fondamental dégénéré ou non en polarisation. Dans ce premier mode de réalisation où le fil photonique 20 présente une section de forme circulaire, il supporte un mode fondamental dégénéré en polarisation (deux polarisations linéaires, et orthogonales entre elles).

En variante, le fil photonique 20 peut présenter une section droite adaptée à ce que les photons émis soient polarisés, comme l'indique l'article de Munsch et al. intitulé Linearly Polarized Single-Mode Spontaneous Emission in a Photonic Nanowire, Phys. Rev. Lett, 108, 077405, 2012. Pour cela, le fil photonique 20 peut présenter une section droite elliptique tout le long de l'axe longitudinal Δ. A titre d'exemple, dans le plan de la boîte quantique, la section droite peut présenter un grand axe de 250nm environ et un petit axe de 150nm environ.

Par ailleurs, le fil photonique 20 comporte un adaptateur de mode permettant d'optimiser l'extraction lumineuse du mode guidé hors du fil photonique 20 et d'obtenir un diagramme d'émission de forme gaussienne à faible ouverture numérique. Plus précisément, le fil photonique 20 présente une variation longitudinale du diamètre local en direction de l'extrémité supérieure 20.2, de manière à dé-confiner progressivement le mode guidé, permettant ainsi d'obtenir un diagramme d'émission en champ lointain plus directif, et ainsi adapté à un couplage efficace avec un guide d'onde externe 43. Ainsi, le diamètre local passe, de préférence d'une manière monotone, d'un premier extremum à son extrémité inférieure 20.1 ou à partir d'une hauteur donnée, à un deuxième extremum différent du premier au niveau de l'extrémité supérieure 20.2.

Dans ce mode de réalisation, le fil photonique 20 présente une forme évasée, dans le sens où le diamètre local passe, suivant la direction +Z, d'une valeur minimale dₘᵢₙ à une valeur maximale dₘₐₓ située à l'extrémité supérieure 20.2. La variation longitudinale peut être monotone et linéaire. Dans cet exemple, le fil photonique 20 présente une forme générale évasée, dans le sens où la valeur minimale dₘᵢₙ est située au niveau de l'extrémité inférieure 20.1, et le diamètre local augmente de manière monotone et sensiblement linéaire de dₘᵢₙ à dₘₐₓ. En variante (non représenté), le fil photonique 20 peut présenter une forme évasée sur une hauteur donnée seulement, et non pas sur toute la hauteur du fil. Aussi, dans ce cas de figure, le diamètre local reste tout d'abord sensiblement constant et égal à dₘᵢₙ sur une hauteur non nulle à partir de l'extrémité inférieure 20.1, puis augmente jusqu'à la valeur maximale dₘₐₓ à l'extrémité supérieure 20.2.

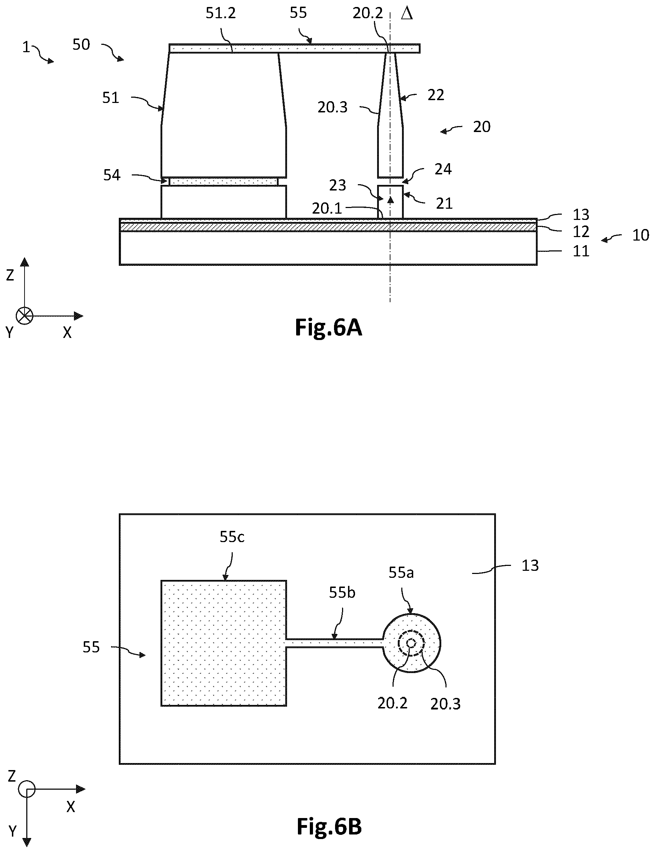

En variante, et comme décrit en détail plus loin (cf. fig.6A-6B), le fil photonique 20 peut présenter une forme effilée, dans le sens où le diamètre local passe, suivant la direction +Z, d'une valeur maximale dₘₐₓ à une valeur minimale dₘᵢₙ située à l'extrémité supérieure 20.2. La variation longitudinale peut être monotone et linéaire. Le fil photonique 20 peut présenter une forme effilée sur toute la hauteur du fil, ou sur une partie du fil seulement. Dans ce dernier cas, suivant la direction +Z, le diamètre local reste tout d'abord sensiblement constant et égal à dₘₐₓ sur une hauteur non nulle, puis diminue jusqu'à l'extrémité supérieure 20.2 qui présente un diamètre local égal à dₘᵢₙ.

A titre d'exemple, dans ce mode de réalisation où le fil photonique 20 présente une forme générale évasée, le fil photonique 20 peut présenter une hauteur de l'ordre de 12µm environ, un diamètre local maximal dₘₐₓ de 1.5µm environ à l'extrémité supérieure 20.2, la boîte quantique 23 étant située à une distance de 100nm environ du substrat support 10 et le diamètre local au niveau de la boîte quantique 23 étant de 200nm environ. Le diamètre local présente une variation longitudinale monotone et sensiblement linéaire avec un angle d'inclinaison α de la bordure latérale sensiblement constant suivant l'axe Z et égale à 3° à 5° environ.

Par ailleurs, dans le cas où le fil photonique 20 présente une forme effilée (fig.6A-6B), le fil photonique 20 peut présenter une hauteur de l'ordre de 10µm, voire moins, un diamètre minimal dₘᵢₙ de 150nm environ à l'extrémité supérieure 20.2, une diminution monotone et linéaire du diamètre local suivant la direction -Z avec un angle d'inclinaison de l'ordre de 1° à 2° environ sur une hauteur de 1µm environ, puis un diamètre local sensiblement constant et égal à 200nm environ jusqu'à l'extrémité inférieure 20.1 du fil photonique 20.

La source de photons uniques 1 comporte un dispositif d'excitation optique 30 adapté à provoquer l'émission spontanée de photons par la boîte quantique 23 en réponse à un signal d'excitation (impulsion laser), et comporte également un dispositif de collection 40 adapté à collecter le signal émis (photons uniques) par l'émetteur 23 en réponse à l'impulsion laser d'excitation et extrait hors du fil photonique 20 suivant la direction +Z.

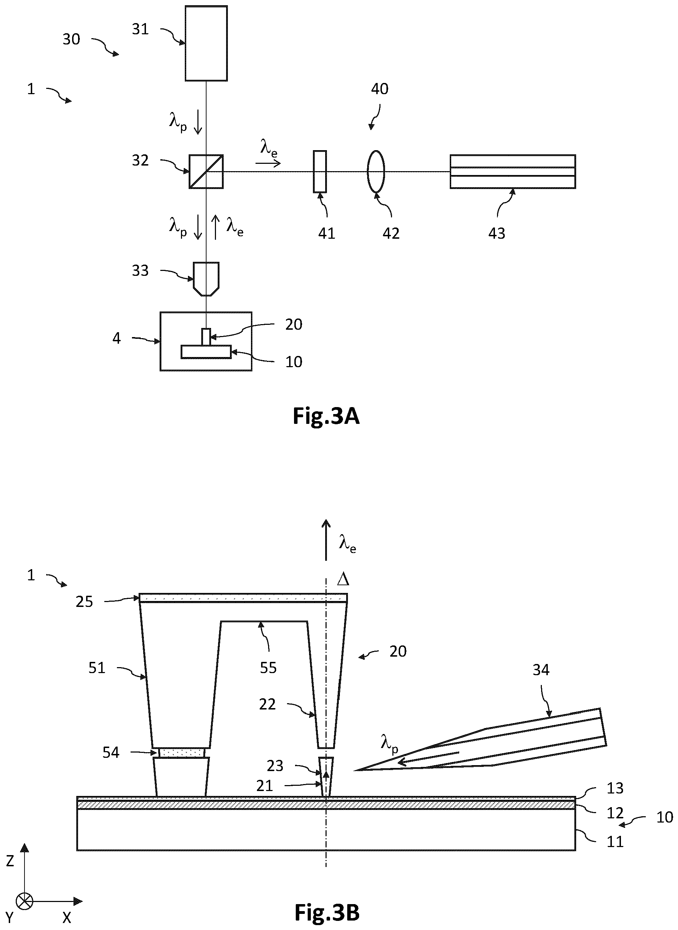

La figure 3A illustre de manière partielle et schématique une variante du dispositif d'excitation optique 30 et du dispositif de collection 40, pour laquelle le chemin optique d'excitation et le chemin optique de collection sont en partie confondus.

Le dispositif d'excitation optique 30 comporte une source laser 31 adaptée à émettre un signal d'excitation (impulsion laser) à une longueur d'onde d'excitation λₚ (ou de pompage) inférieure ou égale à la longueur d'onde d'émission λₑ de la boîte quantique. La source laser 31 peut être un laser titane-saphir dont la longueur d'onde λₚ est par exemple égale à 820nm. La cadence de répétition peut être de 80MHz environ voire davantage (quelques GHz), et la largeur typique des impulsions laser peut être de l'ordre de la picoseconde, voire moins.

Dans cet exemple, le chemin optique des impulsions laser est défini par des optiques non représentées de telle sorte que le signal d'excitation soit incident sur le fil photonique 20 de manière colinéaire avec l'axe longitudinal Δ. Le signal d'excitation traverse une lame semi-réfléchissante 32, puis un microscope confocal 33 qui focalise le signal d'excitation sur le fil photonique 20.

Pour que l'émetteur présente une émission spectralement fine, le fil photonique 20 et le substrat support 10 sont disposés dans un cryostat 4 de manière à porter la température à une valeur de préférence inférieure à quelques dizaines de kelvins.

Les photons émis sont extraits hors du fil photonique 20 suivant l'axe longitudinal Δ au travers de l'extrémité supérieure, et orientés suivant la direction +Z, puis transmis par le microscope confocal 33, réfléchis par la lame semi-réfléchissante 32, et sont collectés par le dispositif de collection 40 qui assure un couplage optique entre le fil photonique 20 et ici un guide d'onde externe 43.

Sur le chemin optique de collection, en aval de la lame semi-réfléchissante 32, le dispositif de collection 40 comporte avantageusement un filtre spectral 41 dans le cas où le fil photonique 20 comporte plusieurs boîtes quantiques situées dans la même couche de mouillage. Le filtre spectral 41 peut comporter un réseau de diffraction et présenter une résolution de 0.1 nm par exemple. Ainsi, dans la mesure où les boîtes quantiques émettent à différentes longueurs d'onde (du fait de leurs tailles différentes et de leurs positions différentes vis-à-vis de l'axe longitudinal Δ dans une même section droite), le filtre spectral 41 permet de sélectionner le faisceau lumineux émis par une boîte quantique 23 particulière, de préférence celle disposée le plus près de l'axe longitudinal. En effet, une telle boîte quantique 23 présente un taux d'émission spontané (*SE rate,* en anglais) élevé, comme l'indique notamment l'article de Claudon et al. intitulé A highly efficient single-photon source based on a quantum dot in a photonic nanowire Nat. Photonics, 4, 174 (2010).

Le dispositif de collection 40 comporte ici une lentille 42 permettant de focaliser le signal émis sur l'entrée d'un guide d'onde externe 43, par exemple une fibre optique. La fibre optique 43 peut ensuite être reliée à un photodétecteur, par exemple à avalanche, ou à tout autre dispositif optique et/ou électronique en fonction de l'application souhaitée de la source de photons uniques 1.

Dans le cas où le signal d'excitation (impulsion laser) présente une même longueur d'onde que le signal émis (photon unique) par le fil photonique 20, notamment dans le cas d'une excitation par pompage optique de manière résonante, un polariseur (non représenté) est disposé sur le chemin optique du signal émis, par exemple entre la lame semi-réfléchissante 32 et le guide d'onde externe 43. Cela permet ainsi de séparer le signal émis de la partie du signal d'excitation diffusée par le fil photonique 20. Cependant, dans cette configuration, la probabilité de collecter les photons émis peut être diminuée, ce qui réduit l'efficacité de la source de photons uniques 1.

Aussi, il est avantageux de dissocier entièrement le chemin optique du signal d'excitation du chemin optique du signal émis par le fil photonique 20. A ce titre, la figure 3B illustre de manière partielle et schématique une autre variante du dispositif d'excitation optique 30 et du dispositif de collection 40, pour laquelle le chemin optique d'excitation et le chemin optique de collection sont entièrement dissociés.

Le dispositif d'excitation optique 30 comporte ainsi un guide d'onde 34 couplé à la source laser 31 et dont l'extrémité d'émission est disposée à proximité et en direction de l'émetteur 23 du fil photonique 20, suivant un angle non nul vis-à-vis de l'axe longitudinal Δ, par exemple un angle supérieur ou égal à 45° et avantageusement proche de 90°. Aussi, le signal d'excitation (impulsion laser) est transmis en direction de la boîte quantique par la bordure latérale du fil photonique 20, et non pas par l'extrémité supérieure et de manière colinéaire à l'axe longitudinal Δ. Dans l'exemple de la fig.3B, le guide d'onde 34 est une fibre optique dont l'extrémité est effilée (ses dimensions transversales diminuent en direction de son extrémité d'émission). Une telle fibre optique (*tapered optical fiber,* en anglais) peut être placée au voisinage du fil photonique 20 par un micromanipulateur à une fraction de micron près, puis solidarisée au substrat support 10 au moyen par exemple d'un matériau adhésif (colle).

Le dispositif de collection 40 peut alors être similaire à celui illustré sur la fig.3A, et il n'est pas nécessaire qu'il comporte un polariseur dans le cas où l'excitation de la boîte quantique est effectuée par pompage résonant dans la mesure où on réduit fortement la probabilité que le dispositif de collection 40 puisse collecter une partie du signal d'excitation diffusée par le fil photonique 20. On augmente ainsi l'efficacité de la source de photons uniques 1.

Comme mentionné précédemment, il a été constaté que les vibrations mécaniques du fil photonique 20, et plus précisément sa déformation vis-à-vis de l'axe longitudinal Δ, génèrent des contraintes mécaniques subies par l'émetteur 23 qui varient dans le temps, ce qui affecte le facteur d'indiscernabilité I de la source de photons uniques 1. En effet, il apparaît qu'un couplage est possible entre les modes de vibration supportés par le fil photonique 20 (et plus précisément les phonons présents) et ici la boîte quantique semiconductrice 23. Aussi, ces contraintes mécaniques, qui varient dans le temps, peuvent alors entraîner une modification dans le temps de la bande d'énergie interdite de la boîte quantique 23 et ainsi provoquer une variation dans le temps de la longueur d'onde des photons émis.

Aussi, le fil photonique 20 est structuré de manière à réduire le couplage possible entre l'émetteur 23 et les contraintes mécaniques issues de la déformation mécanique du fil photonique 20. Pour cela, le fil photonique 20 est segmenté en deux parties distinctes, dites inférieure 21 et supérieure 22, coaxiales suivant l'axe longitudinal Δ, et distantes l'une de l'autre d'une distance dₛₚ non nulle. La partie inférieure 21 comporte l'émetteur 23 et la partie supérieure 22 comporte de préférence l'essentiel de l'adaptateur de mode. La partie supérieure 22 est alors suspendue au-dessus de la partie inférieure 21, et est maintenue en position par une structure de maintien 50.

La partie inférieure 21 repose au contact du substrat support 10, et comporte l'émetteur 23. De préférence, elle comporte une hauteur h₁ telle que le volume de la partie inférieure 21 est inférieure au volume de la partie supérieure 22, de manière à réduire l'impact des modes de vibration qu'elle peut supporter sur les propriétés de l'émetteur 23. De préférence, dans le cas d'un fil photonique 20 de forme générale évasée, la hauteur h₁ est de préférence inférieure à la moitié de la hauteur h, et avantageusement très inférieure à la moitié de la hauteur h. Autrement dit, de préférence h₁/h≤0.5, et de préférence h₁/h≤0.1, et de préférence encore hₚₐ/h≤0.05. Dans cet exemple où la hauteur h du fil photonique 20 est égale à 12µm environ, la hauteur h₁ de la partie inférieure 21 est égale à 200nm environ. La hauteur h₁ est définie comme étant la distance suivant l'axe Z entre l'extrémité inférieure du fil photonique 20 au contact du substrat support 10 et une face supérieure sensiblement plane orientée suivant la direction +Z.

La partie inférieure 21 présente un diamètre local sensiblement égal à λₑ/n dans la section droite où se trouve l'émetteur 23, ici compris par exemple entre 150nm et 300nm, de préférence égal à 200nm environ.

L'émetteur 23 est de préférence situé à une distance de 100nm environ du substrat support 10 (ici le premier ventre d'interférence entre le faisceau incident et le faisceau réfléchi par la couche réflectrice), de manière à optimiser la réflexion du mode guidé, et est de préférence disposé sur l'axe longitudinal Δ ou à une distance dans le plan XY inférieure ou égale à 50nm vis-à-vis de l'axe longitudinal Δ, de manière à optimiser le taux d'émission spontanée.

La partie supérieure 22 est distincte et distante de la partie inférieure 21, dans le sens où il n'y a pas de contact physique direct entre ces deux parties. Elle est disposée de manière coaxiale à la partie inférieure 21 suivant l'axe longitudinal Δ, et est suspendue au-dessus de celle-ci d'une distance dₛₚ non nulle suivant l'axe longitudinal Δ.

La partie supérieure 22 comporte au moins une portion de l'adaptateur de mode, et de préférence l'essentiel de l'adaptateur de mode, en particulier lorsque le fil photonique 20 présente une forme générale évasée. Dans le cas où le fil photonique 20 présente une forme localement effilée, la partie supérieure 22 comporte de préférence entièrement l'adaptateur de mode.

Elle présente une hauteur h2 définie comme la distance entre une face inférieure 22.1 sensiblement plane orientée suivant la direction -Z et l'extrémité supérieure 20.2 du fil photonique 20. La distance suivant l'axe longitudinal Δ entre la face supérieure 21.2 et la face inférieure 22.1 définit un espacement 24 (cf. fig.2A) entre les deux parties inférieure 21 et supérieure 22 et est notée dₛₚ.

La partie supérieure 22 est maintenue dans une position suspendue au-dessus de la partie inférieure 21 par la structure de maintien 50, laquelle est formée d'au moins un bras de maintien 55 qui relie dans un plan XY la partie supérieure 22 à un pilier 51 adjacent au fil photonique 20.

De préférence, la partie inférieure 21 et la partie supérieure 22 présente, de part et d'autre de l'espacement 24, un angle d'inclinaison α identique. Ainsi, le fil photonique 20 ne présente pas une rupture de variation du diamètre local d'un côté et de l'autre de l'espacement 24, c'est-à-dire une variation brusque du diamètre local, de manière ainsi à limiter les pertes optiques.

L'espacement 24 de valeur dₛₚ entre la partie inférieure 21 et la partie supérieure 22 permet le découplage mécanique entre les deux parties inférieure 21 et supérieure 22, tout en assurant un couplage optique du mode guidé entre les deux parties 21, 22. Par couplage optique, on entend que le mode guidé peut se transmettre d'une partie à l'autre avec un coefficient de transmission T au moins égal à 50%.

La distance dₛₚ présente ainsi une valeur choisie entre une valeur minimale d_{sp_min} et une valeur maximale d_{sp_max}. La valeur minimale d_{sp_min} est liée aux contraintes du procédé de fabrication de la source de photons uniques 1 : il s'agit en effet d'assurer la suspension de la partie supérieure 22 par suppression d'une couche sacrificielle située initialement entre la partie inférieure 21 et la partie supérieure 22. La valeur minimale d_{sp_min} peut être de l'ordre de 5nm notamment lorsqu'une attaque chimique à l'acide fluorhydrique (HF) en phase vapeur ou liquide est mise en oeuvre pour supprimer la couche sacrificielle à base d'AlAs, par exemple en AlGaAs pauvre en Ga (GaₓAl₁₋ₓAs avec x≤0.4). Cette valeur minimale d_{sp_min} peut bien entendu être adaptée en fonction du matériau de la couche sacrificielle et de l'agent de gravure utilisé.

La valeur maximale d_{sp_max} dépend de la valeur choisie du coefficient de transmission T du mode guidé entre la partie inférieure 21 et la partie supérieure 22, lequel dépend notamment du diamètre local du fil photonique 20 au niveau de l'espacement 24 (c'est-à-dire de part et d'autre de l'espacement 24). En effet, le coefficient de transmission T diminue évidemment à mesure qu'augmente la valeur dₛₚ de l'espacement 24. Dans cet exemple d'un fil photonique 20 en GaAs à boîte quantique en InAs, pour un diamètre local du fil photonique 20 au niveau de l'espacement 24 compris entre 160nm et 190nm environ, le coefficient T reste supérieur ou égal à 90% pour un espacement 24 allant de 5nm à 50nm environ. En revanche, pour un diamètre local du fil photonique 20 au niveau de l'espacement 24 de valeur dₛₚ compris entre 200nm et 300nm environ, le coefficient T est supérieur ou égal à 90% pour un espacement 24 de valeur dₛₚ allant de 5nm à 10nm environ. Le diamètre local du fil photonique 20 au niveau de l'espacement 24 est défini comme étant la moyenne entre le diamètre local de la face supérieure 21.2 de la partie inférieure 21 et le diamètre local de la face inférieure 22.1 de la partie supérieure 22 (cf. fig.2A). D'une manière générale, la valeur maximale d_{sp,max} est inférieure ou égale à λₑ/n, de préférence inférieure ou égale à λₑ/(2n), voire à λₑ/(4n), et de préférence encore égale à λₑ/(5n), améliorant ainsi le coefficient de transmission T.

Aussi, la valeur dₛₚ de l'espacement 24 est de préférence comprise entre 5nm et 50nm, en particulier pour un diamètre local du fil photonique 20 au niveau de l'espacement 24 compris entre 160nm et 300nm, dans le cas d'un fil photonique 20 en GaAs à boîte quantique en InAs. De préférence, la valeur dₛₚ est comprise entre 5nm et 50nm pour un diamètre local au niveau de l'espacement 24 compris entre 160nm et 190nm, et est de préférence comprise entre 5nm et 10nm pour un diamètre local au niveau de l'espacement 24 compris entre 200nm et 300nm.

La structure de maintien 50 assure la suspension de la partie supérieure 22 au-dessus de la partie inférieure 21 (cf. fig.2A et 2B). Elle comporte au moins un pilier 51 reposant sur le substrat support 10 et disposé de manière adjacente au fil photonique 20, et au moins un bras de maintien 55 reliant au pilier 51 la partie supérieure 22 suspendue. Dans cet exemple, la structure comporte plusieurs piliers 51 disposés autour du fil photonique 20, la partie supérieure 22 étant reliée aux piliers 51 par des bras de maintien 55.

Les piliers 51 présentent un rapport de forme hauteur sur dimensions transversales tel qu'ils sont sensiblement rigides, c'est-à-dire pas ou peu déformables dans un plan orthogonal à l'axe Z. Ils présentent une hauteur sensiblement égale à celle du fil photonique 20 et sont réalisés à base du même matériau cristallin que celui du fil photonique 20, à savoir ici du GaAs. Ils présentent un diamètre local au niveau de l'extrémité inférieure 51.1 au contact du substrat support 10 de préférence au moins égal à plusieurs centaines de nanomètres, par exemple supérieur ou égal à 2µm ou davantage.

Dans cet exemple, chaque pilier 51 comporte une couche intercalaire 54 dans un plan XY, disposée entre deux parties 52, 53 en GaAs, et coplanaire avec l'espacement 24 du fil photonique 20. Cette couche intercalaire 54 est réalisée en le matériau sacrificiel utilisé dans le procédé de fabrication pour l'obtention de la suspension de la partie supérieure 22 au-dessus de la partie inférieure 21. Alors que le diamètre local du fil photonique 20 au niveau de ce matériau sacrificiel est faible et permet la suspension de la partie supérieure 22, le diamètre local de chaque pilier 51 au niveau de ce matériau sacrificiel 54 est important de sorte qu'il n'est pas entièrement supprimé, et assure donc le contact mécanique entre les deux parties 52, 53 réalisées en GaAs.

Les bras de maintien 55 assurent la liaison mécanique entre la partie supérieure 22 du fil photonique 20 et les piliers 51. Ils peuvent être réalisés en le matériau cristallin de haut indice, ici en GaAs, ou être réalisés en un matériau différent. Ils présentent une hauteur de l'ordre de quelques centaines de nanomètres à quelques microns, par exemple 1.5µm, et une largeur maximale dans le plan de l'extrémité supérieure de l'ordre de quelques centaines de nanomètres, par exemple 200nm. Dans cet exemple, les bras de maintien 55 sont réalisés en GaAs et ont été obtenus lors d'une étape de gravure de type RIE de réalisation du fil photonique 20. Ils présentent donc une largeur locale qui diminue suivant la direction -Z. La largeur maximale est inférieure au diamètre local du fil photonique 20 au niveau de l'extrémité supérieure 20.2, de préférence inférieure ou égale au cinquième du diamètre local. Les bras de maintien 55 peuvent présenter une longueur dans le plan XY de l'ordre de quelques microns, par exemple 6µm. Les bras de maintien 55 s'étendent, à l'interface avec le fil photonique 20, à partir de la bordure latérale du fil photonique 20, sur une hauteur donnée de la partie supérieure 22 suivant l'axe Z, et en direction des piliers 51 dans le plan XY.

Dans le cas où la structure de maintien 50 comporte plusieurs piliers 51 et bras de maintien 55, au moins deux piliers 51 sont disposés de manière opposée deux à deux vis-à-vis de l'axe longitudinal Δ. Dans le cas d'un nombre impair de piliers 51, ceux-ci peuvent être disposés de manière à présenter une symétrie de rotation d'ordre impair vis-à-vis de l'axe longitudinal Δ.

Aussi, la segmentation du fil photonique 20 en deux parties coaxiales, distinctes et distantes l'une de l'autre suivant l'axe longitudinal Δ, permet d'obtenir une source de photons uniques 1 dont le facteur d'indiscernabilité I est fortement amélioré par rapport à l'exemple de l'art antérieur décrit en référence à la fig.1B.

En effet, la segmentation du fil photonique 20 permet de réduire l'influence des vibrations mécaniques du fil photonique 20 sur les propriétés de l'émetteur 23. Plus précisément, les variations temporelles de la déformation mécanique du fil photonique 20 présentent un impact fortement réduit sur l'émetteur 23 du fait du découplage mécanique entre la partie supérieure 22 et la partie inférieure 21 du fil photonique 20. En effet, la segmentation du fil photonique 20 en deux parties distinctes conduit à réduire le nombre de modes de vibration que peut supporter la partie inférieure 21, lesquels modes de vibration présentent par ailleurs une fréquence plus élevée. Ceci conduit à réduire fortement la probabilité de couplage entre un tel mode de vibration et l'émetteur 23, améliorant ainsi le facteur d'indiscernabilité I. Par ailleurs, l'efficacité de la source de photons uniques 1 reste particulièrement élevée du fait du fort couplage optique entre la partie inférieure 21 et la partie supérieure 22.

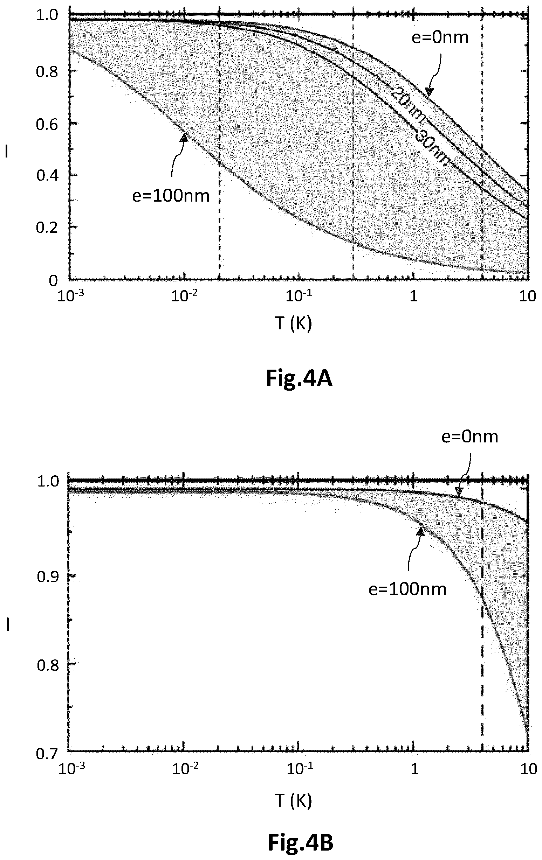

A ce titre, la figure 4A illustre une évolution du facteur d'indiscernabilité I en fonction de la température T dans le cas d'un fil photonique 20 selon l'exemple de l'art antérieur illustré en fig.1B.

D'une manière générale, les vibrations du réseau cristallin du matériau cristallin de haut indice du fil photonique 20 peuvent conduire à la formation de contraintes mécaniques dans la boîte quantique semiconductrice. Un phonon (acoustique) correspond à un mode de vibration du réseau cristallin, et peut donc se coupler avec la boîte quantique semiconductrice. Ce couplage dépend notamment de la température du fil photonique 20. L'utilisation de températures cryogéniques permet de réduire fortement la population de phonons supportés par le fil photonique 20, et donc le couplage entre la boîte quantique et les phonons. Mais celui-ci reste non nul et affecte donc le facteur d'indiscernabilité I.

Dans cet exemple, le fil photonique 20 présente une forme générale évasée et présente une hauteur de 12µm environ, un diamètre local à l'extrémité supérieure de 1.5µm environ et un angle d'inclinaison α constant suivant l'axe longitudinal Δ de 3° environ. Il est réalisé en GaAs et comporte une unique boîte quantique en InAs située à 100nm au-dessus du substrat support 10. Celle-ci peut être disposée vis-à-vis de l'axe longitudinal Δ avec un écart e nul, un écart de 20nm, 30nm ou être disposée sur la bordure latérale (e=100nm). Les différentes courbes caractéristiques de cet écart e sont illustrées sur la fig.3A. Le fil photonique 20 repose au contact d'une couche diélectrique 13 en Si₃N₄ de 10nm d'épaisseur environ, et est disposé en regard suivant l'axe Z d'une couche réflectrice 12 en or d'une épaisseur de 200nm environ.

L'évolution du facteur d'indiscernabilité I en fonction de la température du fil photonique 20 a été obtenue ici en simulant les modes de vibration mécanique à l'aide du logiciel COMSOL Multiphysics, et en appliquant le formalisme développé dans l'article de Muljarov & Zimmermann intitulé Dephasing in Quantum Dots: Quadratic Coupling to Acoustic Phonons, Phys. Rev. Lett, 93, 237401 (2004).

Il apparaît d'une part que le facteur d'indiscernabilité I diminue différemment à mesure que la température augmente, selon que la boîte quantique est située sur l'axe longitudinal Δ, ou est désaxé de l'axe avec un écart e. Ainsi, à une température donnée, le facteur d'indiscernabilité I est plus élevé lorsque la boîte quantique est proche de l'axe longitudinal Δ.Il apparaît également que le facteur d'indiscernabilité présente une chute importante à partir de 0.03K à mesure que la température T augmente, lorsque la boîte quantique est proche de l'axe longitudinal Δ (e≤30nm). Ainsi, à la température de 4K, le facteur d'indiscernabilité I présente une valeur de 50% environ lorsque la boîte quantique est sur l'axe longitudinal Δ (e=onm) et il présente une valeur de 5% environ lorsqu'elle est située à la bordure latérale (e=100nm) du fil photonique 20.

La figure 4B illustre une évolution du facteur d'indiscernabilité I en fonction de la température T dans le cas d'un fil photonique 20 selon le premier mode de réalisation.

Dans cet exemple, le fil photonique 20 est similaire à celui correspondant à la fig.4A, et s'en distingue essentiellement en ce qu'il est segmenté en deux parties, une partie inférieure 21 comportant une boîte quantique en InAs et présentant une hauteur de 200nm environ. La partie supérieure 22 est espacée de la partie inférieure 21 d'une valeur dₛₚ égale à 10nm, et est maintenue suspendue par quatre bras de maintien 55 opposés deux à deux vis-à-vis de l'axe longitudinal Δ.Chaque bras de maintien 55 présente une largeur maximale de 200nm au niveau de l'extrémité supérieure du fil photonique 20, qui diminue suivant la direction -Z sur une hauteur de 1.5µm environ. Les bras de maintien 55 présentent une longueur de 6µm.

Il apparaît que le facteur d'indiscernabilité I est fortement amélioré par rapport au fil photonique 20 selon l'art antérieur. En effet, dans le cas où la boîte quantique est sur l'axe longitudinal Δ (e=onm), le facteur I reste supérieur ou égal à 0.97 pour une température inférieure ou égale à 4K. A la température de 4K, cela correspond à une amélioration de 94% environ du facteur d'indiscernabilité I. Dans le cas où la boîte quantique est située sur la bordure latérale (e=100nm), le facteur I reste supérieur ou égal à 0.87 environ pour une température inférieure ou égale à 4K. A la température de 4K, cela correspond à une amélioration de plus de 1600% environ du facteur d'indiscernabilité I. Ainsi, la segmentation du fil photonique 20 en deux parties distinctes et coaxiales comme décrit précédemment permet de réduire fortement l'influence des vibrations mécaniques du fil photonique 20 sur les propriétés de l'émetteur 23, et ainsi d'obtenir un facteur d'indiscernabilité I particulièrement élevé.

Notons par ailleurs que la source de photons uniques 1 garde les caractéristiques avantageuses propres aux fils photoniques monomodes. En effet, une telle source de photons uniques 1 présente un facteur de pureté P (absence d'impulsion par émission spontanée contenant plus de 1 photon) proche de 1, et un facteur d'efficacité E (probabilité que l'impulsion par émission spontanée contienne effectivement 1 photon) proche de 1. Le fil photonique 20, par l'adaptateur de mode, présente un diagramme d'émission à faible ouverture numérique, ce qui permet un couplage efficace à un guide d'onde externe 43. Par ailleurs, il est possible de réaliser une source de photons uniques 1 accordable en longueur d'onde, en appliquant à la partie inférieure 21 du fil photonique 20 un champ externe (par ex. champ électrique ou un champ de contrainte mécanique généré par un actuateur piézoélectrique) modifiant l'énergie de bande interdite de la boîte quantique semiconductrice, sans que cela affecte le facteur d'efficacité E de la source de photons uniques 1.

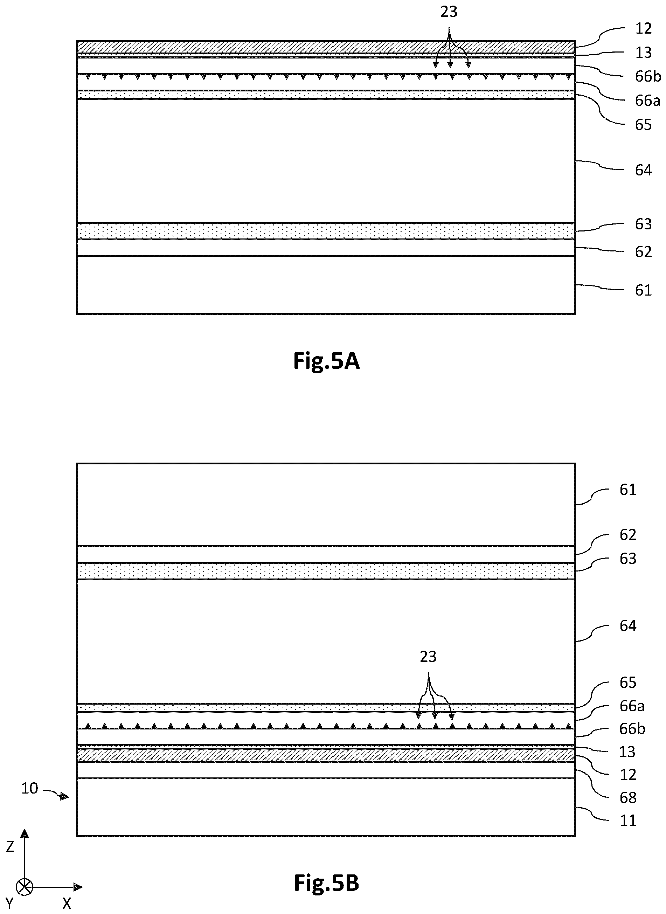

Un exemple de procédé de fabrication de la source de photons uniques 1 selon le premier mode de réalisation est maintenant décrit, en référence aux figures 5A à 5H qui illustrent différentes étapes du procédé.

Lors d'une première étape (fig.5A), on réalise un empilement de couches épitaxiées à partir d'un premier substrat 61. Le premier substrat 61 est de préférence réalisé en un matériau cristallin présentant une faible différence du paramètre de maille avec le matériau cristallin principal du fil photonique 20. Dans cet exemple, le premier substrat 61 est réalisé en GaAs.

L'épitaxie des couches en question peut être une épitaxie par jets moléculaires (MBE, pour *Molecular Beam Epitaxy,* en anglais) ou une épitaxie en phase vapeur aux organométalliques (MOCVD pour *MetalOrganic Chemical Vapor Déposition,* en anglais), ou toute autre technique d'épitaxie équivalente.

L'empilement est formé des couches suivantes, disposées les unes sur les autres à partir du premier substrat :
- une première couche 62, dite couche tampon, en GaAs de 500nm d'épaisseur environ, déposée au contact du premier substrat 61 ;
- une première couche sacrificielle 63, par exemple réalisée à base de AlAs, ici de l'AlGaAs avec 80%at. d'Al, de 500nm d'épaisseur environ ;
- une deuxième couche 64 en le matériau cristallin de haut indice du fil photonique 20, ici en GaAs, d'une épaisseur correspondant à la hauteur h₂ souhaitée de la partie supérieure 22, par exemple 12µm environ ;
- une deuxième couche sacrificielle 65, par exemple à base d'AlAs, ici de l'AlGaAs avec 80%at d'Al, d'une épaisseur correspondant à la distance souhaitée dₛₚ de l'espacement 24 entre la partie inférieure 21 et la partie supérieure 22, par exemple une épaisseur comprise entre 5nm et 50nm ;
- une sous-couche 66a en le matériau cristallin de haut indice, ici en GaAs, destinée à former une portion de la partie inférieure 21, par exemple d'une épaisseur de 100nm environ ;
- une couche active, formée d'une couche de mouillage réalisée en le composé semiconducteur formant les boîtes quantiques 23, par exemple en InAs, et des boîtes quantiques (seules les boîtes quantiques 23 sont représentées, ici par des triangles) ;
- une autre sous-couche 66b en le matériau cristallin de haut indice, ici en GaAs, destinée à former une autre portion de la partie inférieure 21, par exemple d'une épaisseur de 100nm environ.

La couche active est réalisée selon les connaissances techniques de l'homme du métier, selon par exemple les conditions décrites dans l'article de Gérard et al. intitulé Optical investigation of the self-organized growth on InAs/GaAs quantum boxes, J. Crystal Growth, 150, 351 (1995). Elle peut présenter une épaisseur de l'ordre de 0.5nm et comporter des boîtes quantiques disposées dans le plan XY avec une densité surfacique par exemple égale à 200 boîtes quantiques par micron.

On réalise ensuite, à partir de la face libre de l'empilement, la couche réflectrice. L'empilement est pour cela revêtue d'une couche diélectrique 13, réalisée en un matériau diélectrique d'une part, et inerte à un agent de gravure utilisé ultérieurement lors d'une étape de réalisation du fil photonique 20 et des bras de maintien 55 et des piliers 51, et inerte à l'agent de gravure utilisé lors de l'étape de segmentation du fil photonique 20 (suspension de la partie supérieure 22). La couche diélectrique 13 peut être un nitrure de silicium, par exemple du Si₃N₄ d'une épaisseur de 10nm environ.

La couche diélectrique 13 est ensuite revêtue d'une couche réflectrice 12 à la longueur d'onde des photons émis par la source de photons uniques 1. La couche réflectrice 12 peut être réalisée en un matériau métallique tel que de l'or d'une épaisseur de 100nm à 300nm environ.

Lors d'une étape suivante (fig.5B), on solidarise l'empilement formé à un deuxième substrat 11. Pour cela, on met en contact la face libre de la couche réflectrice 12 avec une couche adhésive 68 réalisée en un matériau adhésif qui revêt un deuxième substrat 11. Celui-ci peut être réalisé en un matériau cristallin éventuellement semiconducteur, par exemple du GaAs dopé ou non. La couche adhésive 68 peut être réalisée en une colle époxy, ou en un polymère tel que du PDMS ou du PMMA. Toute autre technique de solidarisation peut être utilisée. Le substrat support 10 sur lequel est destiné à reposer le fil photonique 20 est alors formé du deuxième substrat 11, de la couche adhésive 68, de la couche réflectrice 12, et de la couche diélectrique 13.

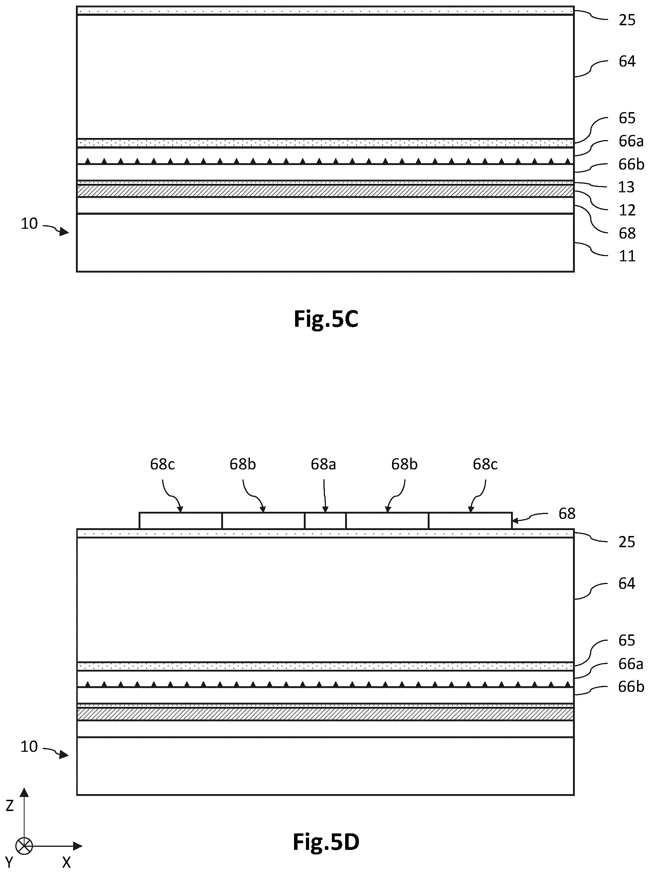

Lors d'une étape suivante (fig.5C), on réalise un amincissement de l'empilement de manière à rendre libre une face de la deuxième couche 64 en GaAs. Pour cela, on réalise par exemple un amincissement du premier substrat 61 par polissage mécano-chimique jusqu'à conserver une épaisseur de GaAs comprise entre 50µm et 100µm environ. On réalise ensuite une gravure chimique du premier substrat 61 aminci et de la couche tampon 62 par un agent de gravure sélectif vis-à-vis de la première couche sacrificielle 63. On réalise enfin une gravure chimique de la première couche sacrificielle 63 par un agent de gravure sélectif vis-à-vis du matériau cristallin principal, par exemple par gravure HF (acide fluorhydrique). On obtient ainsi une face libre de la deuxième couche 64 en GaAs de bonne propriétés optiques (faibles rugosités), minimisant ainsi les éventuelles pertes optiques au niveau de cette face.

Lors d'une étape suivante, on dépose une couche antireflet 25 sur la face libre de la deuxième couche 64 en GaAs. Cette couche antireflet 25 forme une lame quart d'onde d'épaisseur λₑ/(4nₐᵣ) où nₐᵣ est l'indice de réfraction de la couche antireflet 25, lequel est proche de √n (n étant l'indice de réfraction du matériau cristallin de haut indice, ici le GaAs). Elle peut être réalisée par exemple en un nitrure de silicium, par exemple du Si₃N₄ déposé par épitaxie en phase vapeur assisté par plasma (PECVD).

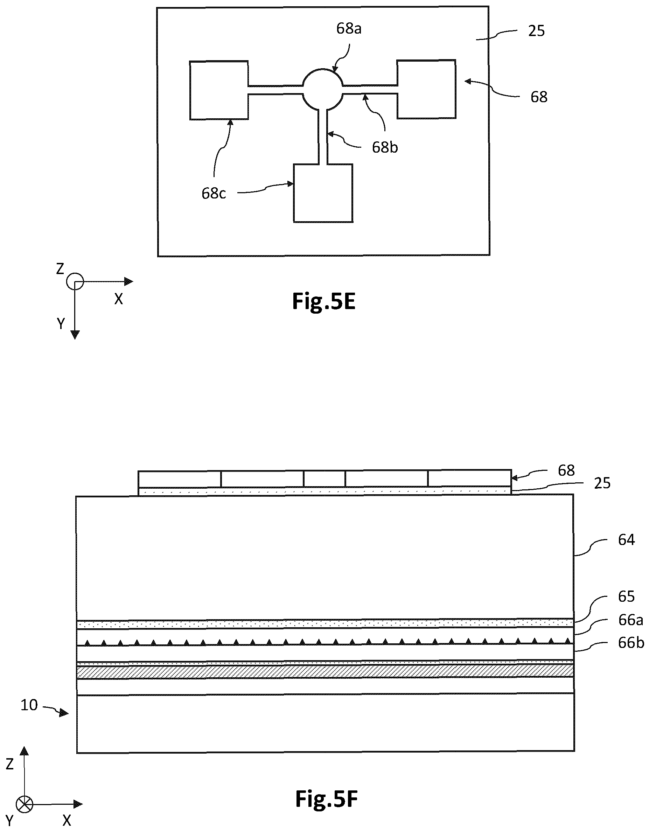

Lors d'une étape suivante (fig.5D et 5E), on réalise un masque de gravure 68 de manière à recouvrir partiellement la couche antireflet 25. Le masque de gravure 68 est destiné à délimiter dans le plan XY le fil photonique 20 et la structure de maintien 50 (piliers 51 et bras). Le masque de gravure 68 est ici réalisé en nickel Ni par lithographie et *lift-off.* Il comporte ainsi une partie centrale 68a destinée à la formation du fil photonique 20, dont les dimensions dans le plan XY définissent celle de l'extrémité supérieure 20.2 du fil photonique 20. Il comporte ici plusieurs parties latérales 68c destinées à la formation des piliers 51, lesquelles sont reliées à la partie centrale 68a par des parties étroites intercalaires 68b destinées à la formation des bras de maintien 55. Dans cet exemple, le fil photonique 20 est relié mécaniquement à trois piliers 51 adjacents.

La partie centrale 68a peut présenter une forme arrondie, par exemple circulaire ou ovale, ou polygonale. Elle est ici circulaire et présente un diamètre d_{pc} qui dépend de l'angle de gravure α qui correspond à l'angle d'inclinaison formé par l'orientation de la bordure latérale 20.3 du fil photonique 20 par rapport à l'axe Z, et par la hauteur h souhaitée du fil photonique 20. Etant donné que l'on souhaite que le diamètre local du fil photonique 20 dans le plan de la boîte quantique 23 soit sensiblement égal à d_{bq}=λₑ/n à une hauteur de l'ordre de 100nm au-dessus du substrat support 10, le diamètre de la partie centrale 68a est sensiblement égale à d_{bq} + 2×h×tan(α). On suppose ici que la hauteur de 100nm de la boîte quantique 23 vis-à-vis du substrat support 10 est négligeable vis-à-vis de la hauteur totale h du fil photonique 20.

La largeur l_{b} des parties intercalaires 68b est de préférence constante dans le plan XY et présente une valeur choisie en fonction de l'angle de gravure α et de la hauteur souhaitée h_{b} des bras de maintien 55. La largeur l_{b} peut être ainsi sensiblement égale à 2×h_{b}×tan(α). Ainsi, pour une hauteur des bras de maintien 55 de l'ordre de 1µm, et un angle de gravure de l'ordre de 3°, la largeur l_{b} des parties intercalaires est de l'ordre de 100nm environ.

Les parties latérales 68c peut présenter une forme arrondie ou polygonale, par exemple ici carrée. Elles présentent des dimensions transversales dans le plan XY, ici une largeur lₚₗ, choisie en fonction de l'angle de gravure α et de la largeur souhaitée au niveau de de l'extrémité inférieure 51.1 des piliers 51 au contact avec le substrat support 10. Comme détaillé plus loin, les piliers 51 doivent être suffisamment larges pour que la couche intercalaire 54 qu'ils comportent ne soit pas entièrement gravée à la suite de l'étape de segmentation du fil photonique 20. A titre d'exemple, pour un pilier 51 dont la largeur inférieure au contact avec le substrat support 10 est égale à 1µm environ, et pour une hauteur de 12µm environ, la largeur lₚₗ des parties latérales est sensiblement égale à 2.25µm environ.

Lors d'une étape suivante (fig.5F), on effectue une gravure localisée de la couche antireflet 25, de manière à supprimer les parties non revêtues par le masque de gravure. La gravure peut être effectuée par exemple par gravure ionique réactive (RIE, pour *Reactive Ion Etching,* en anglais), et de préférence de sorte que les flancs gravés de la couche antireflet 25 soient sensiblement orientés suivant l'axe Z. Ainsi, la deuxième couche 64 en GaAs présente une face supérieure avec une surface libre, c'est-à-dire non revêtue par la couche antireflet 25 et par le masque de gravure 68.

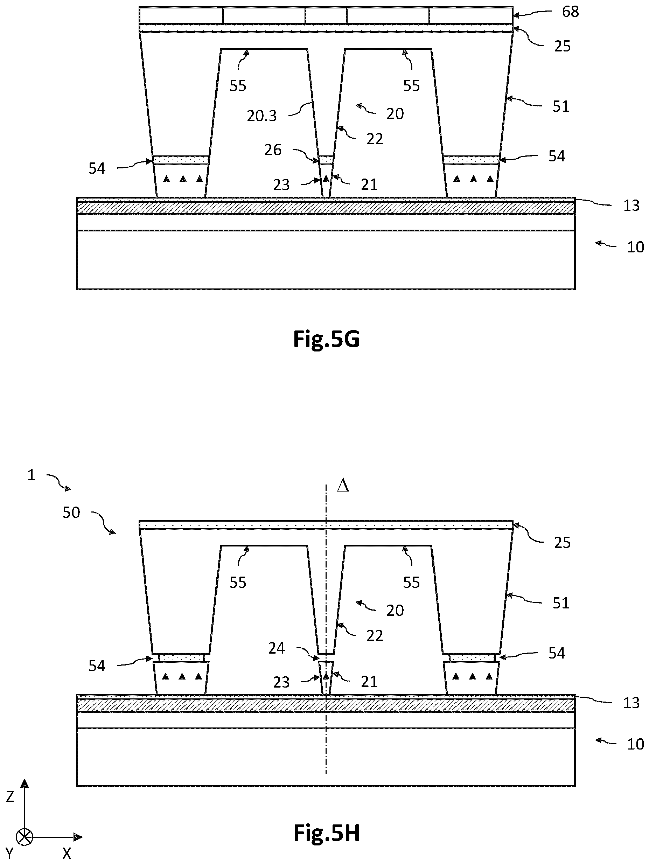

Lors d'une étape suivante (fig.5G), on réalise le fil photonique 20, ainsi que les bras de maintien 55 et les piliers 51, ici par une gravure localisée de l'empilement. La gravure peut être effectuée par gravure ionique réactive (RIE) dont les caractéristiques en termes de gravure physique et gravure chimique sont définies de manière à obtenir l'angle de gravure α voulu, par exemple 3° environ. La couche diélectrique 13 forme une couche d'arrêt de gravure. Aussi, l'agent de gravure grave dans le plan XY une partie de la deuxième couche 64 en GaAs, une partie de la deuxième couche sacrificielle 65, et une partie des deux sous-couches 66a, 66b en GaAs. On obtient ainsi un fil photonique 20 qui contient une ou plusieurs boîtes quantiques 23 à une hauteur de 100nm environ pour laquelle le diamètre local est sensiblement égal à 200nm environ. Le fil photonique 20 s'étend continûment suivant l'axe Z entre la couche antireflet 25 et le substrat support 10, et la deuxième couche sacrificielle 65 devient une portion intercalaire 26 qui participe à former la bordure latérale 20.3 du fil photonique 20 orientée suivant l'angle d'inclinaison a. Elle assure encore la liaison mécanique entre la partie supérieure 22 et la partie inférieure 21. On obtient également les bras de maintien 55 réalisés en GaAs, et qui présentent une hauteur h_{bm} voulue, ici de l'ordre de 1µm, et on obtient les piliers 51 qui présentent des dimensions transversales voulues au niveau du contact avec le substrat support 10. Les bras de maintien 55 assurent une liaison mécanique entre les piliers 51 et le fil photonique 20. La couche antireflet 25 recouvre continûment la face supérieure du fil photonique 20, des bras de maintien 55 et des piliers 51. A la suite de cette étape, le masque de gravure est supprimé, par exemple à l'aide d'une solution acide.

Lors d'une étape suivante (fig.5H), on effectue la segmentation du fil photonique 20, autrement dit, on effectue la suspension de la partie supérieure 22 du fil photonique 20 au-dessus de la partie inférieure 21. Pour cela, on effectue une gravure chimique du matériau de la seconde couche sacrificielle à base d'AlAs, cette gravure chimique étant sélective vis-à-vis du matériau cristallin de haut indice (ici le GaAs) de la deuxième couche et des deux sous-couches, ainsi que vis-à-vis du matériau diélectrique (ici un SiN) de la couche diélectrique 13. L'agent de gravure est de préférence de l'acide fluorhydrique (HF) en phase vapeur. Le temps de gravure est choisi de manière à obtenir la suspension de la partie supérieure 22 au-dessus de la partie inférieure 21, sans liaison mécanique directe entre ces deux parties, sans pour autant que la couche sacrificielle présente dans les piliers 51 soit entièrement gravée. Aussi, la liaison mécanique verticale entre les couches en GaAs au sein des piliers 51 reste préservée. La partie supérieure 22 est alors suspendue au-dessus de la partie inférieure 21 par les bras de maintien 55, lesquels reliées mécaniquement la partie supérieure 22 aux piliers 51 adjacents.

Dans cet exemple, le fil photonique 20 peut comporter plusieurs boîtes quantiques situés dans un même plan XY de sa partie inférieure 21. En effet, la section droite où se trouvent les boîtes quantiques présente une surface de l'ordre de 0.04µm² et la densité de boîtes quantiques est de l'ordre de 200/µm². Il en résulte qu'il y a en moyenne environ 8 boîtes quantiques dans la partie inférieure 21 du fil photonique 20, distribuées spatialement de manière aléatoire dans une même section droite. Ces boîtes quantiques peuvent ainsi être disposées à différentes distances de l'axe longitudinal Δ, et émettent des photons à des longueurs d'onde différentes d'une boîte quantique à l'autre (variabilité de tailles).

Dans ce cas, comme décrit précédemment, le dispositif de collection 40 de la source de photons uniques 1 comporte avantageusement un filtre spectral 41 (cf. fig.3A) de manière à isoler les photons émis par une boîte quantique choisie, de préférence la plus proche de l'axe longitudinal Δ dans la mesure où elle présente un taux d'émission spontanée le plus élevé.

On obtient ainsi une source de photons uniques 1 formée d'un fil photonique 20 segmenté en deux parties distinctes et distantes l'une de l'autre, et disposées de manière coaxiale vis-à-vis de l'axe longitudinal Δ. Le découplage mécanique entre ces deux parties permet d'améliorer fortement le facteur d'indiscernabilité I de la source de photons uniques 1, alors même que le couplage optique entre les deux parties est maintenu. La structure de maintien 50 assure le maintien de la partie supérieure 22 dans une position suspendue au-dessus de la partie inférieure 21.

Les figures 6A et 6B sont des vues schématiques et partielles, en coupe longitudinale (fig.6A) et en vue de dessus (fig.6B), d'une source de photons uniques 1 selon un deuxième mode de réalisation.

La source de photons uniques 1 se distingue de celle du premier mode de réalisation essentiellement en ce que le fil photonique 20 présente une forme effilée. Le fil photonique 20 forme un guide d'onde monomode pour les photons émis par l'émetteur 23, et comporte un adaptateur de mode dans la partie supérieure 22 optimisant l'extraction lumineuse et permettant d'obtenir un diagramme d'émission de forme gaussienne et à faible ouverture numérique. Dans cet exemple, le fil photonique 20 est réalisé à base de GaAs et comporte au moins une boîte quantique semiconductrice en InAs.

Comme précédemment, la partie inférieure 21 repose au contact du substrat support 10, et comporte l'émetteur 23. Elle présente ici un diamètre local dans la section droite contenant la boîte quantique proche de λₑ/n, par exemple ici 200nm environ. Elle présente une hauteur h₁ ici égale à 200nm environ. L'émetteur 23 est disposé à une hauteur de 100nm environ vis-à-vis du substrat support 10. Dans cet exemple, la partie inférieure 21 présente un diamètre local sensiblement constant suivant l'axe longitudinal Δ.

La partie supérieure 22 est disposée de manière coaxiale à la partie inférieure 21 vis-à-vis de l'axe longitudinal Δ. Elle est suspendue au-dessus de la partie inférieure 21 d'un espacement 24 d'une valeur dₛₚ de préférence comprise entre 5nm et 50nm. Ainsi, il y a un découplage mécanique entre les parties inférieure et supérieure mais le couplage optique entre les deux parties est préservé avec un coefficient de transmission T élevé du mode guidé.

La partie supérieure 22 présente ici une première portion dont le diamètre local est sensiblement constant suivant l'axe longitudinal Δ, et égal à λₑ/n, par exemple ici 200nm environ, et une deuxième portion qui s'étend jusqu'à l'extrémité supérieure dont le diamètre local diminue progressivement suivant la direction +Z de manière à former un adaptateur de mode.

La structure de maintien 50, ici formée d'un pilier 51 et d'un bras de maintien 55, assure le maintien de la partie supérieure 22 en position suspendue au-dessus de la partie inférieure 21. Comme dans le premier mode de réalisation, le pilier 51 est réalisé à base du même matériau que le matériau cristallin de haut indice du fil photonique 20.

A la différence du premier mode de réalisation, le bras de maintien 55 n'est pas réalisé à base du matériau cristallin de haut indice, mais en un matériau différent. Il est formé d'une portion d'appui 55c qui repose sur l'extrémité supérieure 51.2 du pilier 51, d'une portion intercalaire 55b de largeur étroite, et d'une portion de maintien 55a qui est solidaire de la partie supérieure 22.

Le bras de maintien 55 est ici réalisé à base d'un matériau électriquement isolant, par exemple un nitrure de silicium tel que le Si₃N₄. Il présente une épaisseur choisie de manière à réduire toute absorption des photons émis par le fil photonique 20 par le bras de maintien 55, et forme par exemple une lame demi-onde d'épaisseur λₑ/(2n_{bm}), par exemple égale à 250nm environ dans le cas du Si₃N₄ et d'une longueur d'onde d'émission λₑ égale à 950nm environ.

La portion de maintien 55a présente de préférence une dimension moyenne dans le plan XY supérieure au diamètre local maximal (ici 200nm) du fil photonique 20, par exemple au moins 2 fois supérieure au diamètre local maximal. De préférence, la portion de maintien 55a présente une forme dans le plan XY ayant une symétrie de révolution autour de l'axe longitudinal Δ, de manière à réduire toute dégradation du diagramme d'émission du faisceau lumineux émis par le fil photonique 20.

La source de photons uniques 1 selon le deuxième mode de réalisation présente les mêmes avantages que ceux décrits précédemment, qui ne sont pas détaillés ici à nouveau.

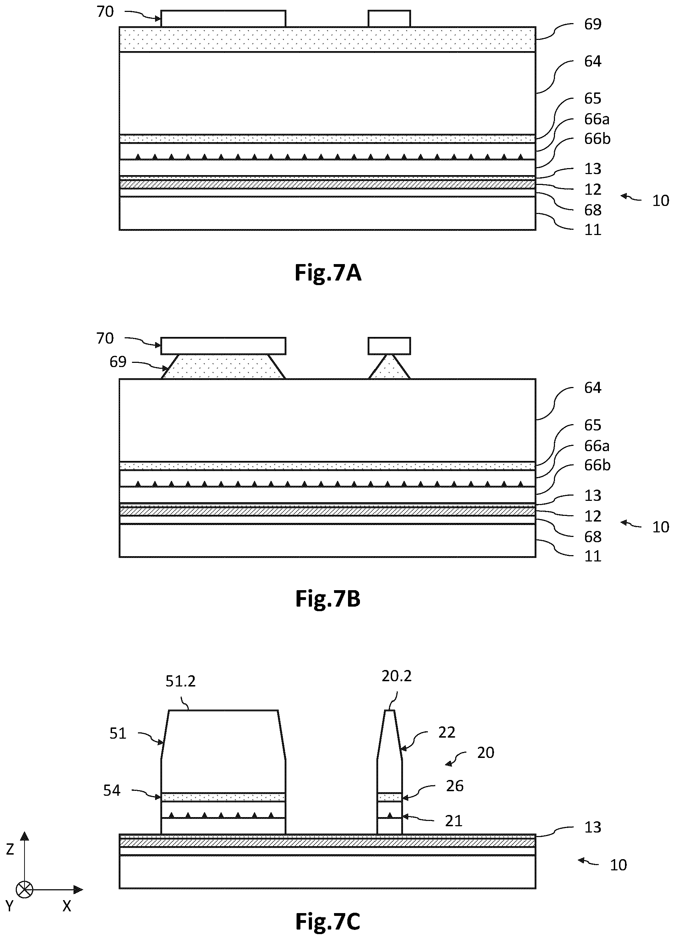

Un exemple de procédé de fabrication de la source de photons uniques 1 selon le deuxième mode de réalisation est maintenant décrit, en référence aux figures 7A à 7F qui illustrent différentes étapes du procédé. Le procédé de fabrication comprend des étapes similaires à celles décrites dans l'article de Claudon et al. intitulé Harnessing Light with Photonic nanowires: Fundamentals and Applications to Quantum Optics, ChemPhysChem, 14, 2393-2402 (2013).

Lors d'une première étape (fig.7A), on réalise un empilement similaire à celui décrit précédemment en référence à la fig.5D. Cet empilement diffère ici de celui décrit précédemment en ce que la deuxième couche 64 en GaAs est revêtue d'une couche 69 en un nitrure de silicium, par exemple du Si₃N₄. Un masque de gravure 70 revêt localement la couche 69 de Si₃N₄, et peut être par exemple réalisé en aluminium Al et est défini dans le plan XY par lithographie à faisceau d'électrons (*e-beam lithography*, en anglais).

Lors d'une étape suivante (fig.7B), on effectue une gravure partielle de la couche 69 de Si₃N₄, par gravure ionique réactive, de sorte qu'elle forme un cône (tronqué) au-dessus de la zone destinée à définir le fil photonique 20. Un autre cône est également formé au-dessus de la zone destinée à définir le pilier 51. Les cônes forment un angle d'inclinaison a' de l'ordre de 20° par rapport à l'axe Z.

Lors d'une étape suivante (fig.7C), on effectue une gravure partielle de l'empilement à base de GaAs sous-jacent par gravure ionique réactive. L'empilement de GaAs est gravé verticalement, et le masque de gravure 70 est progressivement gravé également. A partir du moment où le masque de gravure 70 est totalement supprimé, le cône de Si₃N₄ est directement exposé. La gravure ionique sélective continue, de sorte que la forme conique du Si₃N₄ est transférée au GaAs. On obtient ainsi un fil photonique 20 dont l'extrémité supérieure 20.2 peut ou non être revêtue par un résidu du cône de Si₃N₄, au côté duquel se trouve le pilier 51 de la structure de maintien 50.

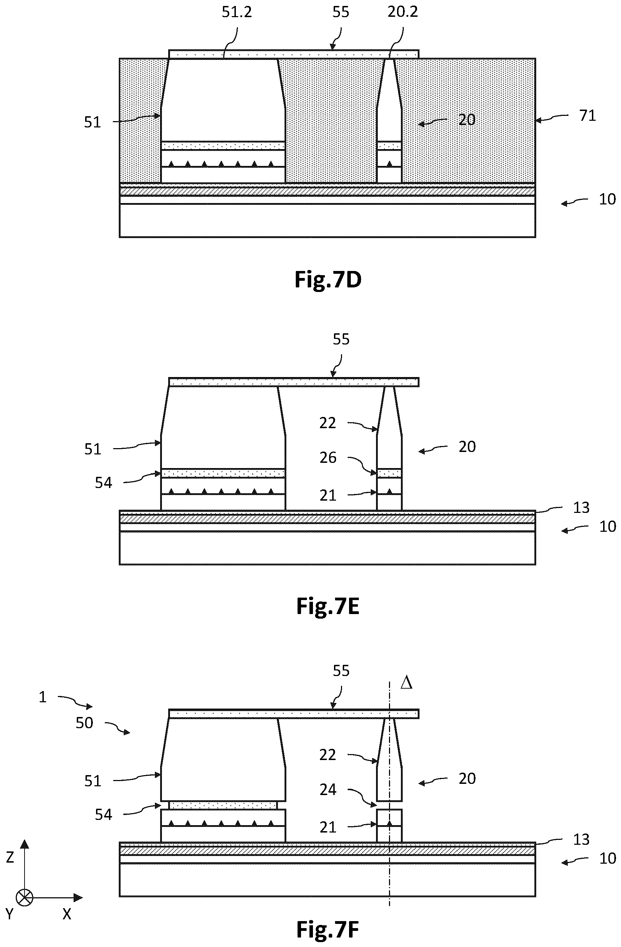

Lors d'une étape suivante (fig.7D), l'ensemble ainsi obtenu est encapsulé dans une couche 71 par exemple de résine, laquelle est ensuite planarisée, par exemple par planarisation mécano-chimique, de manière à rendre libre l'extrémité supérieure 51.2 du pilier 51 et l'extrémité supérieure 20.2 du fil photonique 20. La résine peut être du BCB (benzocyclobutène) entre autres.

Lors d'une étape suivante (fig.7E), le bras de maintien 55 est réalisé par dépôt d'une couche de bas indice, par exemple du Si₃N₄ d'une épaisseur de l'ordre ici de 250nm, et on définit par lithographie la portion d'appui 55c, la portion intercalaire 55b, et la portion de maintien 55a. Le bras de maintien 55 est ainsi au contact du pilier 51 au niveau de sa portion d'appui 55c, et au contact du fil photonique 20 au niveau de sa portion de maintien 55a. On supprime ensuite la résine 71 de manière à suspendre les portions intercalaire 55b et de maintien 55a du bras de maintien 55.

Lors d'une étape suivante (fig.7F), on effectue la suspension de la partie supérieure 22 vis-à-vis de la partie inférieure 21, par gravure des portions 54 et 26 de la couche sacrificielle 65, laquelle est sélective vis-à-vis du bras de maintien 55 et du matériau cristallin de haut indice. Le temps de gravure est ajusté de manière à supprimer entièrement la portion 26 présente dans le fil photonique 20, et à ne pas supprimer entièrement la portion 54 présente dans le pilier 51.

On obtient ainsi une source de photons uniques 1 formée d'un fil photonique 20 segmenté en deux parties distinctes et coaxiales. Le découplage mécanique entre ces deux parties permet d'améliorer sensiblement le facteur d'indiscernabilité I de la source de photons uniques 1, alors même que le couplage optique entre les deux parties limite les pertes optiques. La structure de maintien 50 assure le maintien de la partie supérieure 22 dans une position suspendue au-dessus de la partie inférieure 21.

Des modes de réalisation particuliers viennent d'être décrits. Différentes variantes et modifications apparaîtront à l'homme du métier.

Ainsi, la source de photons uniques 1 selon le premier mode de réalisation comporte des bras de maintien 55 réalisés en le matériau cristallin de haut indice, ici de GaAs. En variante, il est possible de réaliser des bras de maintien 55 en un matériau distinct de celui du matériau cristallin de haut indice du fil photonique 20. Ainsi, des bras de maintien 55 identiques ou similaires à celui décrit en référence aux fig.6A et 6B peuvent être réalisés. Ces bras de maintien 55 peuvent également être réalisés en un matériau métallique, et former au niveau de l'extrémité supérieure du fil photonique 20, une couronne s'étendant uniquement au niveau de la bordure de celle-ci, de manière à laisser libre une surface supérieure permettant l'extraction lumineuse des photons émis. A titre d'exemple, la couronne peut présenter une largeur de 100 à 200nm, l'épaisseur de la portion intercalaire du bras de maintien 55 une largeur de 200 à 500nm environ et une longueur de l'ordre de 5 à 20µm. La couche métallique peut présenter une épaisseur de l'ordre de 100 à 500nm environ. La réalisation d'un tel bras de maintien 55 peut être similaire au procédé décrit dans l'article de Böckler et al. intitulé Electrically driven high-Q quantum dot-micropillar cavities, Appl. Phys. Lett. 92, 091107 (2008).

On a décrit précédemment des exemples de réalisation dans lesquels l'émetteur 23 émet des photons uniques de longueur d'onde égale à 950nm environ. Il est possible d'adapter les caractéristiques du fil photonique 20 de manière à émettre des photons dans la longueur d'onde des télécommunications optiques, c'est-à-dire à 1.3µm environ et à 1.55µm environ.

Comme mentionné précédemment, la source de photons uniques 1 peut être accordée en longueur d'onde, par exemple par l'application d'une contrainte mécanique au sein du substrat support 10, lequel serait alors un substrat piézoélectrique, une telle contrainte mécanique serait alors transmise à la partie inférieure 21 du fil photonique 20.

Il est également possible d'accorder la source de photons uniques 1 en longueur d'onde par l'application d'un champ électrique statique à l'émetteur 23 de manière à modifier l'énergie de bande interdite de la boîte quantique. A titre d'exemple, le substrat en GaAs peut être fortement dopé n, et la partie supérieure 22 en GaAs est fortement dopée p sur les premiers 100 à 500nm suivant la direction +Z. Par l'utilisation d'un bras de maintien 55 en un matériau électriquement conducteur, et en appliquant une différence de potentiels entre le bras de maintien 55 et le substrat support 10, un champ électrique est généré qui permet de modifier les propriétés de la boîte quantique.

## Revendications

1. Source de photons uniques (1), comportant :
∘ un substrat support (10) comportant une couche réflectrice (12) ;
∘ un fil photonique (20),
• reposant sur le substrat support (10) et disposé en regard de la couche réflectrice (12), et s'étendant suivant un axe longitudinal Δ sensiblement orthogonal au plan du substrat support (10) ;
• comportant un émetteur (23) de photons uniques ;
• formant un guide d'onde monomode pour les photons uniques ; et
• présentant des dimensions transversales variant longitudinalement en direction d'une extrémité supérieure (20.2) du fil photonique (20), de manière à former un adaptateur de mode pour un mode optique guidé ;
∘ un dispositif d'excitation optique (30) adapté à exciter l'émetteur (23) par une impulsion laser, et ainsi à provoquer l'émission spontanée de photons uniques par l'émetteur (23) ;
∘ **caractérisée en ce que** le fil photonique (20) est formé de deux parties coaxiales, distinctes et distantes l'une de l'autre suivant l'axe longitudinal Δ :
• une partie inférieure (21), reposant au contact du substrat support (10), dans laquelle est disposé l'émetteur (23),
• une partie supérieure (22), suspendue au-dessus de la partie inférieure (21) et couplée optiquement à celle-ci,
∘ et **en ce que** la source de photons uniques (1) comporte en outre une structure de maintien (50), comportant :
• au moins un pilier (51) reposant au contact du substrat support (10) et disposé de manière adjacente au fil photonique (20), et
• au moins un bras de maintien (55) reliant mécaniquement la partie supérieure (22) au pilier (51) et maintenant la partie supérieure (22) suspendue au-dessus de la partie inférieure (21).

2. Source de photons uniques (1) selon la revendication 1, dans laquelle la partie inférieure (21) présente un volume inférieur à celui de la partie supérieure (22).

3. Source de photons uniques (1) selon la revendication 1 ou 2, dans laquelle la partie supérieure (22) comporte l'adaptateur de mode.

4. Source de photons uniques (1) selon l'une quelconque des revendications 1 à 3, dans laquelle la partie supérieure (22) est espacée de la partie inférieure (21) d'une distance dₛₚ comprise entre 5nm et λₑ/n, où λₑ est la longueur d'onde des photons émis par l'émetteur et où n est l'indice de réfraction du matériau cristallin du fil photonique.

5. Source de photons uniques (1) selon l'une quelconque des revendications 1 à 4, dans laquelle le fil photonique (20) et le pilier (51) sont réalisés à base d'un même matériau cristallin.

6. Source de photons uniques (1) selon l'une quelconque des revendications 1 à 5, dans laquelle le pilier (51) comporte une portion intercalaire (54) en un matériau sacrificiel, disposée entre deux parties (52, 53) du pilier (51) réalisées en le matériau cristallin, cette portion intercalaire (54) étant coplanaire avec l'espacement (24) entre les parties inférieure (21) et supérieure (22) du fil photonique (20).

7. Source de photons uniques (1) selon l'une quelconque des revendications 1 à 6, dans laquelle le bras de maintien (55) est réalisé en ledit même matériau cristallin, et s'étend dans un plan parallèle au plan du substrat support (10) à partir d'une bordure latérale (20.3) de la partie supérieure (22).

8. Source de photons uniques (1) selon l'une quelconque des revendications 1 à 6, dans laquelle le bras de maintien (55) est réalisé en un matériau différent dudit matériau cristallin, et s'étend sur et au contact d'une extrémité supérieure (20.2) du fil photonique (20) opposée au substrat support (10).

9. Source de photons uniques (1) selon l'une quelconque des revendications 1 à 8, dans laquelle le fil photonique (20) présente une forme évasée ou une forme effilée suivant une direction opposée au substrat support (10).

10. Source de photons uniques (1) selon les revendications 8 et 9, dans lequel le fil photonique (20) présente une forme effilée, et le bras de maintien (55) présente une portion de maintien (55a) partiellement au contact de la partie supérieure (22), la portion de maintien (55a) présentant une symétrie de rotation autour de l'axe longitudinal Δ ainsi qu'une dimension moyenne dans un plan parallèle au substrat support (10) supérieure à une valeur maximale des dimensions transversales du fil photonique (20).

11. Source de photons uniques (1) selon l'une quelconque des revendications 1 à 10, dans laquelle le fil photonique (20) est réalisé à base d'un matériau cristallin choisi parmi les composés III-V ou les composés II-VI, et dans laquelle l'émetteur (23) est formé d'au moins une boîte quantique semiconductrice.

12. Procédé de fabrication d'une source de photons uniques (1) selon l'une quelconque des revendications précédentes, comportant les étapes suivantes :
∘ réalisation d'un empilement, comportant :
• un substrat support (10), comportant une couche réflectrice (12) revêtue d'une couche diélectrique (13) d'arrêt de gravure ;
• une première et une deuxième sous-couches (66a, 66b), reposant au contact de la couche diélectrique (13), réalisées en un matériau cristallin dit de haut indice, entre lesquelles est située un émetteur (23), destinées à former la partie inférieure (21) ;
• une couche sacrificielle (65), reposant au contact de la deuxième sous-couche (66a) ;
• une deuxième couche (64), reposant au contact de la couche sacrificielle (65), et destinée à former la partie supérieure (22) ;
∘ gravure partielle de l'empilement de manière à former le pilier (51) et le fil photonique (20), une portion (54) de la couche sacrificielle (65) participant alors à définir une bordure latérale du pilier (51), et une portion (26) de la couche sacrificielle (65) participant alors à définir une bordure latérale du fil photonique (20) ;
∘ gravure sélective de la couche sacrificielle (65), de manière à supprimer la portion (54) de la couche sacrificielle (65) du fil photonique (20), et assurant ainsi la suspension de la partie supérieure (22) au-dessus de la partie inférieure (21), tout en préservant au moins une partie de la portion (54) de la couche sacrificielle (65) du pilier (51).

13. Procédé de fabrication selon la revendication 12, dans lequel le bras de maintien (55) est réalisé lors de l'étape de formation du pilier (51) et du fil photonique (20), et assure la liaison mécanique entre le pilier (51) et la partie supérieure (22) du fil photonique (20).

14. Procédé de fabrication selon la revendication 13, dans lequel, à la suite de l'étape de formation du pilier (51) et du fil photonique (20), la partie supérieure (22) n'est pas liée mécaniquement au pilier (51), le procédé comportant les étapes suivantes :
∘ dépôt d'une couche d'encapsulation (71) recouvrant le pilier (51) et le fil photonique (20), et planarisation de la couche d'encapsulation (71) de manière à rendre libre une extrémité supérieure (51.2) du pilier (51) et une extrémité supérieure (20.2) du fil photonique (20) ;
∘ réalisation d'un bras de maintien (55) s'étendant sur la couche d'encapsulation (71) et au contact de l'extrémité supérieure (51.2) du pilier (51) et de l'extrémité supérieure (20.2) du fil photonique (20) ;
∘ suppression de la couche d'encapsulation (71) ;
∘ gravure sélective de la couche sacrificielle (65), assurant ainsi la suspension de la partie supérieure (22) au-dessus de la partie inférieure (21).

## Patentansprüche

1. Einzelphotonenquelle (1), umfassend:
∘ ein Trägersubstrat (10), das eine reflektierende Schicht (12) umfasst;
∘ einen photonischen Draht (20),
• der auf dem Trägersubstrat (10) aufliegt und gegenüber der reflektierenden Schicht (12) angeordnet ist und der sich entlang einer Längsachse Δ erstreckt, die im Wesentlichen senkrecht zur Ebene des Trägersubstrats (10) verläuft;
• der einen Einzelphotonen-Emitter (23) umfasst;
• der einen Einmodenwellenleiter für die Einzelphotonen bildet; und
• der Quermaße aufweist, die längs in Richtung eines oberen Endes (20.2) des photonischen Drahts (20) variieren, so dass ein Modenadapter für eine geführte optische Mode gebildet wird;
∘ eine Vorrichtung zur optischen Anregung (30), die geeignet ist, den Emitter (23) durch einen Laserimpuls anzuregen und so die spontane Aussendung von Einzelphotonen durch den Emitter (23) zu bewirken;
∘ **dadurch gekennzeichnet, dass** der photonische Draht (20) aus zwei koaxialen, verschiedenen und voneinander entlang der Längsachse Δ entfernten Teilen gebildet wird:
• einem Unterteil (21), das berührend auf dem Trägersubstrat (10) aufliegt und in dem der Emitter (23) angeordnet ist,
• einem Oberteil (22), das über dem Unterteil (21) hängt und mit diesem optisch gekoppelt ist,
∘ und dass die Einzelphotonenquelle (1) ferner eine Haltestruktur (50) umfasst, die umfasst:
• mindestens einen Pfeiler (51), der berührend auf dem Trägersubstrat (10) aufliegt und benachbart zum photonischen Draht (20) angeordnet ist, und
• mindestens einen Haltearm (55), der das Oberteil (22) mechanisch mit dem Pfeiler (51) verbindet und das Oberteil (22) über dem Unterteil (21) hängend hält.

2. Einzelphotonenquelle (1) nach Anspruch 1, bei der das Unterteil (21) ein geringeres Volumen als das Oberteil (22) aufweist.

3. Einzelphotonenquelle (1) nach Anspruch 1 oder 2, bei der das Oberteil (22) den Modenadapter umfasst.

4. Einzelphotonenquelle (1) nach einem der Ansprüche 1 bis 3, bei der das Oberteil (22) von dem Unterteil (21) um eine Distanz dₛₚ zwischen 5nm und λₑ/n beabstandet ist, wobei λₑ die Wellenlänge der vom Emitter ausgesendeten Photonen ist und wobei n der Brechungsindex des kristallinen Materials des photonischen Drahts ist.

5. Einzelphotonenquelle (1) nach einem der Ansprüche 1 bis 4, bei welcher der photonische Draht (20) und der Pfeiler (51) auf der Basis desselben kristallinen Materials ausgeführt sind.

6. Einzelphotonenquelle (1) nach einem der Ansprüche 1 bis 5, bei welcher der Pfeiler (51) einen Zwischenabschnitt (54) aus einem Opfermaterial umfasst, der zwischen zwei Teilen (52, 53) des Pfeilers (51) angeordnet ist, die aus dem kristallinen Material ausgeführt sind, wobei dieser Zwischenabschnitt (54) komplanar zu dem Abstand (24) zwischen dem Unterteil (21) und dem Oberteil (22) des photonischen Drahts (20) ist.

7. Einzelphotonenquelle (1) nach einem der Ansprüche 1 bis 6, bei welcher der Haltearm (55) aus demselben kristallinen Material ausgeführt ist und sich in einer parallel zur Ebene des Trägersubstrats (10) verlaufenden Ebene ausgehend von einem seitlichen Rand (20.3) des Oberteils (22) erstreckt.

8. Einzelphotonenquelle (1) nach einem der Ansprüche 1 bis 6, bei welcher der Haltearm (55) aus einem von dem kristallinen Material verschiedenen Material ausgeführt ist und sich auf und in Berührung mit einem oberen Ende (20.2) des photonischen Drahts (20) erstreckt, das zum Trägersubstrat (10) entgegengesetzt ist.

9. Einzelphotonenquelle (1) nach einem der Ansprüche 1 bis 8, bei welcher der photonische Draht (20) eine aufgeweitete Form oder verjüngte Form entlang einer zum Trägersubstrat (10) entgegengesetzten Richtung aufweist.

10. Einzelphotonenquelle (1) nach den Ansprüchen 8 und 9, bei welcher der photonische Draht (20) eine verjüngte Form aufweist und der Haltearm (55) einen Halteabschnitt (55a) aufweist, der teilweise in Berührung mit dem Oberteil (22) ist, wobei der Halteabschnitt (55a) eine Rotationssymmetrie um die Längsachse Δ sowie ein mittleres Maß in einer parallel zu dem Trägersubstrat (10) verlaufenden Ebene aufweist, das größer als ein maximaler Wert der Quermaße des photonischen Drahts (20) ist.

11. Einzelphotonenquelle (1) nach einem der Ansprüche 1 bis 10, bei welcher der photonische Draht (20) auf der Basis eines kristallinen Materials ausgeführt ist, das unter den III-V-Verbindungen oder den II-VI-Verbindungen gewählt ist, und bei welcher der Emitter (23) aus mindestens einem Halbleiterquantenpunkt gebildet wird.

12. Verfahren zur Herstellung einer Einzelphotonenquelle (1) nach einem der vorhergehenden Ansprüche, das die folgenden Schritte umfasst:
∘ Ausführen eines Schichtsystems, das umfasst:
• ein Trägersubstrat (10), das eine reflektierende Schicht (12) umfasst, die mit einer dielektrischen Ätzstopschicht (13) überzogen ist;
• eine erste und eine zweite Teilschicht (66a, 66b), die berührend auf der dielektrischen Schicht (13) aufliegen und aus einem kristallinen sogenannten Hochindexmaterial ausgeführt sind, zwischen denen ein Emitter (23) gelegen ist und die dazu bestimmt sind, das Unterteil (21) zu bilden;
• eine Opferschicht (65), die berührend auf der zweiten Teilschicht (66a) aufliegt;
• eine zweite Schicht (64), die berührend auf der Opferschicht (65) aufliegt und dazu bestimmt ist, das Oberteil (22) zu bilden;
∘ teilweises Ätzen des Schichtsystems, so dass der Pfeiler (51) und der photonische Draht (20) gebildet werden, wobei ein Abschnitt (54) der Opferschicht (65) daraufhin dazu beiträgt, einen seitlichen Rand des Pfeilers (51) zu definieren, und ein Abschnitt (26) der Opferschicht (65) daraufhin dazu beiträgt, einen seitlichen Rand des photonischen Drahts (20) zu bilden;
∘ selektives Ätzen der Opferschicht (65), so dass der Abschnitt (54) der Opferschicht (65) des photonischen Drahts (20) entfernt wird und so das Hängen des Oberteils (22) über dem Unterteil (21) gewährleistet wird, wobei gleichzeitig mindestens ein Teil des Abschnitts (54) der Opferschicht (65) des Pfeilers (51) erhalten bleibt.

13. Herstellungsverfahren nach Anspruch 12, bei dem der Haltearm (55) bei dem Schritt des Bildens des Pfeilers (51) und des photonischen Drahts (20) ausgeführt wird und die mechanische Verbindung zwischen dem Pfeiler (51) und dem Oberteil (22) des photonischen Drahts (20) gewährleistet.

14. Herstellungsverfahren nach Anspruch 13, bei dem, nach dem Schritt des Bildens des Pfeilers (51) und des photonischen Drahts (20), das Oberteil (22) nicht mechanisch mit dem Pfeiler (51) verbunden ist, wobei das Verfahren die folgenden Schritte umfasst:
∘ Aufbringen einer Kapselungsschicht (71), die den Pfeiler (51) und den photonischen Draht (20) bedeckt, und Glätten der Kapselungsschicht (71), so dass ein oberes Ende (51.2) des Pfeilers (51) und ein oberes Ende (20.2) des photonischen Drahts (20) freigelegt werden;
∘ Ausführen eines Haltearms (55), der sich auf der Kapselungsschicht (71) und in Berührung mit dem oberen Ende (51.2) des Pfeilers (51) und dem oberen Ende (20.2) des photonischen Drahts (20) erstreckt;
∘ Entfernen der Kapselungsschicht (71);
∘ selektives Ätzen der Opferschicht (65), wodurch das Hängen des Oberteils (22) über dem Unterteil (21) gewährleistet wird.

## Claims

1. Single-photon source (1), comprising:
∘ a support substrate (10) comprising a reflective layer (12);
∘ a photonic wire (20),
• resting on the support substrate (10) and arranged facing the reflective layer (12), and extending along a longitudinal axis Δ substantially orthogonal to the plane of the support substrate (10);
• comprising a single-photon emitter (23);
• forming a monomode waveguide for the single photons; and
• having transverse dimensions that vary longitudinally in the direction of an upper end (20.2) of the photonic wire (20), so as to form a mode adapter for a guided optical mode;
∘ an optical excitation device (30) designed to excite the emitter (23) through a laser pulse, and thus to cause the spontaneous emission of single photons by the emitter (23);
∘ **characterized in that** the photonic wire (20) is formed of two coaxial parts that are separate and spaced from one another along the longitudinal axis Δ;
• a lower part (21), resting in contact with the support substrate (10), in which the emitter (23) is arranged,
• an upper part (22), suspended above the lower part (21) and optically coupled thereto,
∘ and **in that** the single-photon source (1) furthermore comprises a holding structure (50), comprising:
• at least one pillar (51) resting in contact with the support substrate (10) and arranged adjacent to the photonic wire (20), and
• at least one holding arm (55) mechanically connecting the upper part (22) to the pillar (51) and holding the upper part (22) suspended above the lower part (21).

2. Single-photon source (1) according to Claim 1, wherein the lower part (21) has a volume smaller than that of the upper part (22).

3. Single-photon source (1) according to Claim 1 or 2, wherein the upper part (22) comprises the mode adapter.

4. Single-photon source (1) according to any one of Claims 1 to 3, wherein the upper part (22) is spaced from the lower part (21) by a distance dₛₚ between 5 nm and λₑ/n, where λₑ is the wavelength of the photons emitted by the emitter and where n is the refractive index of the crystalline material of the photonic wire.

5. Single-photon source (1) according to any one of Claims 1 to 4, wherein the photonic wire (20) and the pillar (51) are made from one and the same crystalline material.

6. Single-photon source (1) according to any one of Claims 1 to 5, wherein the pillar (51) comprises a spacer portion (54) made of a sacrificial material, arranged between two parts (52, 53) of the pillar (51) made of the crystalline material, this spacer portion (54) being coplanar with the spacing (24) between the lower part (21) and upper part (22) of the photonic wire (20).

7. Single-photon source (1) according to any one of Claims 1 to 6, wherein the holding arm (55) is made of said same crystalline material, and extends in a plane parallel to the plane of the support substrate (10) from a lateral edge (20.3) of the upper part (22).

8. Single-photon source (1) according to any one of Claims 1 to 6, wherein the holding arm (55) is made of a material different from said crystalline material, and extends over and in contact with an upper end (20.2) of the photonic wire (20) opposite the support substrate (10).

9. Single-photon source (1) according to any one of Claims 1 to 8, wherein the photonic wire (20) has a flared shape or a tapered shape along a direction opposite the support substrate (10).

10. Single-photon source (1) according to Claims 8 and 9, wherein the photonic wire (20) has a tapered shape, and the holding arm (55) has a holding portion (55a) partially in contact with the upper part (22), the holding portion (55a) exhibiting rotational symmetry about the longitudinal axis Δ and also an average dimension, in a plane parallel to the support substrate (10), greater than a maximum value of the transverse dimensions of the photonic wire (20).

11. Single-photon source (1) according to any one of Claims 1 to 10, wherein the photonic wire (20) is made from a crystalline material chosen from among III-V compounds or II-VI compounds, and wherein the emitter (23) is formed of at least one semiconductor quantum box.

12. Method for producing a single-photon source (1) according to any one of the preceding claims, comprising the following steps:
∘ forming a stack comprising:
• a support substrate (10), comprising a reflective layer (12) coated with a dielectric etch stop layer (13);
• a first and a second sublayer (66a, 66b), resting in contact with the dielectric layer (13), made of what is called a high-index crystalline material, between which there is located an emitter (23), and which are intended to form the lower part (21);
• a sacrificial layer (65), resting in contact with the second sublayer (66a);
• a second layer (64), resting in contact with the sacrificial layer (65), and intended to form the upper part (22);
∘ partially etching the stack so as to form the pillar (51) and the photonic wire (20), a portion (54) of the sacrificial layer (65) then contributing to defining a lateral edge of the pillar (51), and a portion (26) of the sacrificial layer (65) then contributing to defining a lateral edge of the photonic wire (20);
∘ selectively etching the sacrificial layer (65) so as to remove the portion (54) of the sacrificial layer (65) from the photonic wire (20), and thus ensuring that the upper part (22) is suspended above the lower part (21), while still preserving at least part of the portion (54) of the sacrificial layer (65) of the pillar (51).

13. Production method according to Claim 12, wherein the holding arm (55) is produced in the step of forming the pillar (51) and the photonic wire (20), and provides the mechanical link between the pillar (51) and the upper part (22) of the photonic wire (20).

14. Production method according to Claim 13, wherein, following the step of forming the pillar (51) and the photonic wire (20), the upper part (22) is not mechanically linked to the pillar (51), the method comprising the following steps:
∘ depositing an encapsulating layer (71) covering the pillar (51) and the photonic wire (20), and planarizing the encapsulating layer (71) so as to expose an upper end (51.2) of the pillar (51) and a lower end (20.2) of the photonic wire (20);
∘ forming a holding arm (55) extending over the encapsulating layer (71) and in contact with the upper end (51.2) of the pillar (51) and the upper end (20.2) of the photonic wire (20);
∘ removing the encapsulating layer (71);
∘ selectively etching the sacrificial layer (65), thus ensuring that the upper part (22) is suspended above the lower part (21).
